# EUROPEAN PATENT APPLICATION

(11) **EP 4 752 635 A1**
(43) Date of publication of application: **03.06.2026**
(21) Application number: 25220037.3
(22) Date of filing: 02.12.2025
(51) Int. Cl.: G03F 7/031, G03F 7/037, G03F 7/038

(54) **POLYIMIDE-BASED PHOTOSENSITIVE COMPOSITION**

(30) Priority: 02.12.2024 KR 20240176049; 26.11.2025 KR 20250182994
(71) Applicant: Duksan Neolux Co., Ltd, Cheonan-si, Chungcheongnam-do (KR)
(72) Inventor: Chung, Yeon Joon, Cheonan-si, Chungcheongnam-do (KR); Park, Yun Hee, Cheonan-si, Chungcheongnam-do (KR); Song, Gwang Sik, Cheonan-si, Chungcheongnam-do (KR); Lee, So Mi, Cheonan-si, Chungcheongnam-do (KR); Kim, Do Eon, Cheonan-si, Chungcheongnam-do (KR)
(74) Representative: BCKIP Part mbB

(57) **Abstract**

According to the present disclosure, a negative photosensitive composition and a method for pattern formation using a polyimide-based precursor and an oxime ester-based compound are provided. The composition, which leaves no residue after development, accurately implemented a pattern with an error of less than 0.5 µm, while the composition, which produces residue, showed an error of up to 5 µm and significant residues. This demonstrates that the oxime ester-based initiator is effective in reducing residues and improving pattern accuracy.

## Description

### TECHNICAL FIELD

The present disclosure relates to a negative photosensitive composition prepared using a polyimide-based precursor and an oxime ester-based compound, and a method pattern formation using the same. The present disclosure also relates to a semiconductor device or display device prepared using the prepared negative photosensitive composition.

### BACKGROUND

A photolithography process largely proceeds in order of a coating step, in which a photoresist composition is applied onto a substrate; an exposure step, in which a pattern is formed on a photoresist layer using a light source, E-beam, *etc.* that has passed through a mask; and a development step, in which specific areas of the patterned photoresist layer are removed; and the process is performed by adding a heat treatment (baking) step to remove the solvent from the photoresist composition or to harden the film in the middle of each step.

The photolithography process may largely be divided into negative and positive processes, and specifically, be divided into a positive process in which, in the development step, the exposed part reacts chemically with a developer and the reaction product is dissolved and removed, and a negative process in which, conversely, the non-exposed area reacts chemically with a developer, and the reaction product is dissolved and removed. Between them, the negative process uses a photoinitiator that absorbs light and generates radicals during the exposure step, and thus has the advantage in that it allows an exposure with a relatively small amount of energy compared to the positive process and excellent adhesion to the oxide film.

In conventional negative photosensitive resin compositions used in semiconductor devices or display devices, various initiators such as oxime-based, thioxanthone-based, diazo compound-based, azo compound-based, and quinone-based can be used, but there are limitations in the resolution and implementation of patterns that can be implemented depending on their structures or characteristics.

### SUMMARY

In order to solve the problems of the related art, the present disclosure aims to improve pattern implementation characteristics by introducing an oxime ester initiator with a specific structure.

Additionally, the present disclosure aims to provide a negative photosensitive composition using the oxime ester initiator.

Additionally, the present disclosure aims to provide a film formed from the negative photosensitive composition and a semiconductor device or display device prepared using the same.

It is preferable that the negative photosensitive composition according to the present disclosure preferably includes a polyimide-based precursor; and an initiator represented by Formula I below. 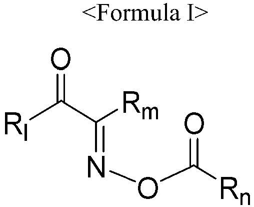 In Formula I above,
R₁ to Rₙ are each independently selected from the group consisting of hydrogen; deuterium; a C₁₋₃₀ alkyl group; a C₁₋₃₀ alkylene group; a C₂-C₂₀ alkenyl group; a C₂-C₂₀ alkynyl group; a C₃₋₃₀ cycloalkyl group; a C₂₋₃₀ Alkylcycloalkyl group; a C₆₋₃₀ aryl group; a fused ring group of a C₆₋₃₀ aliphatic ring and a C₆₋₃₀ aromatic ring; a C₂₋₃₀ alkenyl group; a C₂₋₃₀ alkynyl group; a C₁₋₃₀ alkoxy group; a C₆₋₃₀ aryloxy group; a carbonyl group; an ether group; and a combination thereof, and
R₁ to Rₙ are each independently further substituted with one or more substituents selected from the group consisting of hydrogen; deuterium; a C₁₋₃₀ alkyl group; a C₁₋₃₀ alkylene group; a C₂-C₂₀ alkenyl group; a C₂-C₂₀ alkynyl group; a C₃₋₃₀ cycloalkyl group; a C₂₋₃₀ Alkylcycloalkyl group; a C₆₋₃₀ aryl group; a fused ring group of a C₆₋₃₀ aliphatic ring and a C₆₋₃₀ aromatic ring; a C₂₋₃₀ alkenyl group; a C₂₋₃₀ alkynyl group; a C₁₋₃₀ alkoxy group; a C₆₋₃₀ aryloxy group; a carbonyl group; an ether group; and a combination thereof, or form a ring between neighboring substituents.

It is more preferable that the compound of Formula I above include Formula J below.

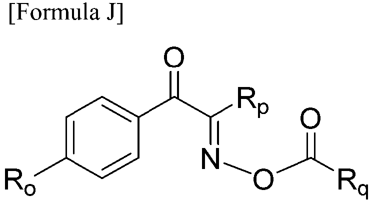

In Formula J above,
Rₒ is hydrogen or a C₁₋₁₀ alkyl group,
Rₚ to R_{q} are each independently selected from the group consisting of hydrogen; deuterium; a C₁₋₃₀ alkyl group; a C₁₋₃₀ alkylene group; a C₂-C₂₀ alkenyl group; a C₂-C₂₀ alkynyl group; a C₃₋₃₀ cycloalkyl group; a C₂₋₃₀ Alkylcycloalkyl group; a C₆₋₃₀ aryl group; a fused ring group of a C₆₋₃₀ aliphatic ring and a C₆₋₃₀ aromatic ring; a C₂₋₃₀ alkenyl group; a C₂₋₃₀ alkynyl group or C₁₋₃₀ alkoxy group; a carbonyl group; an ether group; and a combination thereof, and
Rₚ to R_{q} are each independently further substituted with one or more substituents selected from the group consisting of hydrogen; deuterium; a C₁₋₃₀ alkyl group; a C₁₋₃₀ alkylene group; a C₂-C₂₀ alkenyl group; a C₂-C₂₀ alkynyl group; a C₃₋₃₀ cycloalkyl group; a C₂₋₃₀ Alkylcycloalkyl group; a C₆₋₃₀ aryl group; a fused ring group of a C₆₋₃₀ aliphatic ring and a C₆₋₃₀ aromatic ring; a C₂₋₃₀ alkenyl group; a C₂₋₃₀ alkynyl group; a C₁₋₃₀ alkoxy group; a C₆₋₃₀ aryloxy group; a carbonyl group; an ether group; and a combination thereof, or form a ring between neighboring substituents.

It is preferable that the compound of Formula I above be selected from Formulas I-1 to I-60 below.

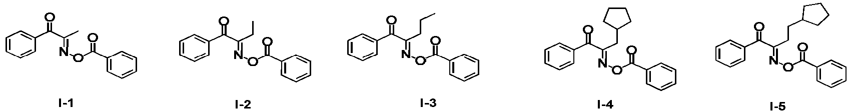

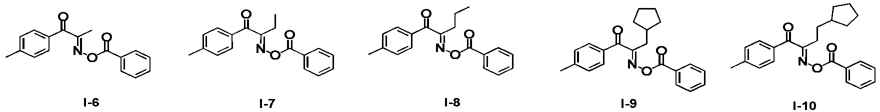

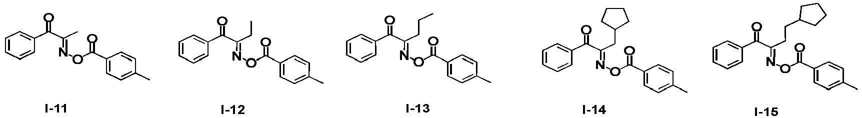

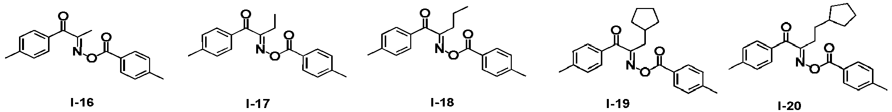

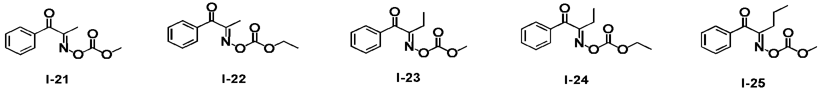

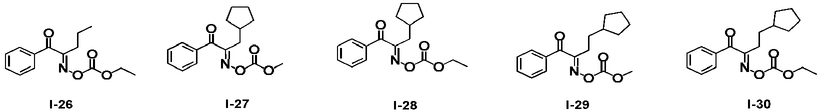

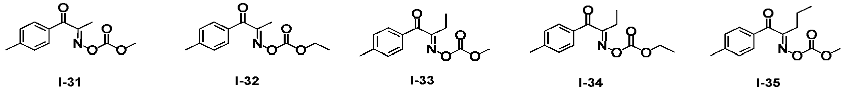

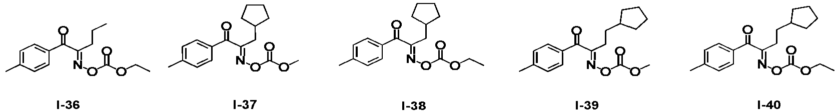

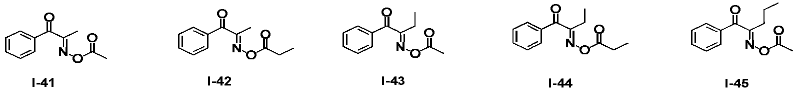

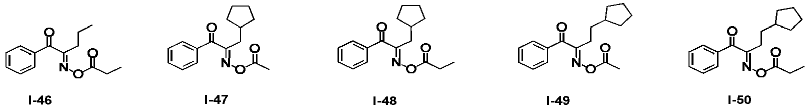

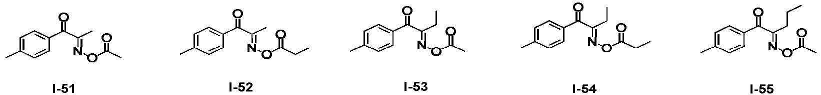

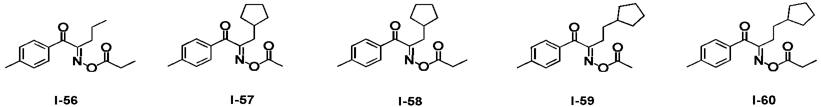

It is preferable that the repeating unit of the polyimide-based precursor according to the present disclosure include the repeating units selected from the group consisting of the following Formulas 1-1 and 1-2, and a combination thereof. 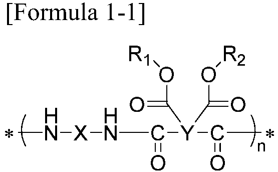 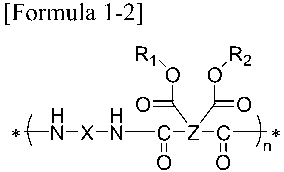 In Formulas 1-1 and Formula 1-2 above,
1) * represents a repeating unit or a part where a bond is connected by a reactive end group represented by Formula Q of claim 2,
2) R₁ to R₄ are Formula 2 below,
3) X is Formula 3 below,
4) m and n are an integer of 1 to 1000, 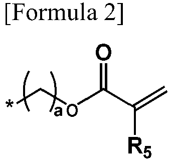 in Formula 2 above,
5) * represents a part where a bond is connected,
6) a is an integer of 1 to 30,
7) R₅ is hydrogen or methyl,
8) Y is selected from the group consisting of a C₆-C₃₀ arylene group; a C₂₋₃₀ heterocyclic group comprising at least one heteroatom among O, N, S, Si, and P; a fused ring group of a C₆₋₃₀ aliphatic ring and a C₆₋₃₀ aromatic ring; a C₁₋₂₀ alkylene group; a C₁₋₂₀ cycloalkylene group; a C₂₋₂₀ alkenylene group; a C₃₋₂₀ cycloalkenylene group; a C₂₋₂₀ alkynylene group; a C₃₋₂₀ cycloalkynylene group; Formula 3; and a combination thereof,
9) Z is selected from the group consisting of a C₆-C₃₀ arylene group; a C₂₋₃₀ heterocyclic group comprising at least one heteroatom among O, N, S, Si, and P; a fused ring group of a C₆₋₃₀ aliphatic ring and a C₆₋₃₀ aromatic ring; a C₁₋₂₀ alkylene group; a C₁₋₂₀ cycloalkylene group; a C₂₋₂₀ alkenylene group; a C₃₋₂₀ cycloalkenylene group; a C₂₋₂₀ alkynylene group; a C₃₋₂₀ cycloalkynylene group; Formula 3; and a combination thereof, 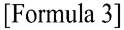 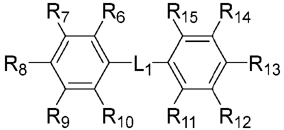
10) L₁ is selected from the group consisting of a single bond, -CH₂-, -CH₂CH₂-, - CH₂OCH₂-, -CH(CH₃)-, -C(CH₃)₂-, -O-, -CH(CF₃)-, -C(CF₃)₂-, -S-, -SO₂-, Si(CH₃)₂-, -C₆H₄-, - OC₆H₄0-, -CO-, -NHCO-, AND -COO-,
11) two of R₆ to R₁₅ are connection parts with an amide group of Formula 1-1 or Formula 1-2 above,
12) the remaining ones of R₆ to R₁₅ excluding the connection parts are each independently hydrogen; deuterium; a hydroxy group; a C₆₋₃₀ aryl group; a C₂₋₃₀ heterocyclic group comprising at least one heteroatom among O, N, S, Si, and P; a fused ring group of a C₆₋₃₀ aliphatic ring and a C₆₋₃₀ aromatic ring; a C₁₋₂₀ alkyl group; a C₂₋₂₀ alkenyl group; a C₂₋₂₀ alkynyl group; a C₁₋₂₀ alkoxy group; a C₆₋₃₀ aryloxy group; a fluorenyl group; a carbonyl group; an ether group; a carboxyl group; a C₁₋₂₀ alkoxycarbonyl group; or neighboring R₆ and R₁₅, and R₁₀ and R₁₁ form a ring, and
13) the rings formed by binding between Y, Z, R₆ to R₁₅, and neighboring groups are each further substituted with one or more substituents selected from the group consisting of deuterium; a halogen; a silane group substituted or unsubstituted with a C₁₋₃₀ alkyl group or C₆₋₃₀ aryl group; a siloxane group; a boron group; a germanium group; a cyano group; an amino group; a nitro group; a C₁₋₃₀ alkylthio group; a C₁₋₃₀ alkoxy group; a C₆₋₃₀ arylalkoxy group; a C₁₋₃₀ alkyl group; a C₂₋₃₀ alkenyl group; a C₂₋₃₀ alkynyl group; a C₆₋₃₀ aryl group; a C₆₋₃₀ aryl group substituted with deuterium; a fluorenyl group; a C₂₋₃₀ heterocyclic group comprising at least one heteroatom among O, N, S, Si, and P; a C₃₋₃₀ alicyclic group; a C₇₋₃₀ arylalkyl group; a C₈₋₃₀ arylalkenyl group; and a combination thereof; or form a ring between neighboring substituents.

It is preferable that the polyimide-based precursor include a polyimide-based repeating unit; and a reactive end group represented by Formula Q that binds to an end of the polyimide-based repeating unit. 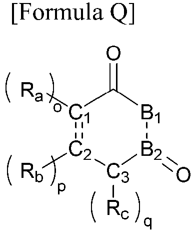 In Formula Q above,
1) Rₐ to R_{c} are each independently hydrogen; deuterium; a hydroxy group; a C₆₋₃₀ aryl group; a C₂₋₃₀ heterocyclic group comprising at least one heteroatom among O, N, S, Si, and P; a fused ring group of a C₆₋₃₀ aliphatic ring and a C₆₋₃₀ aromatic ring; a C₁₋₃₀ alkyl group; a C₂₋₃₀ alkenyl group; a C₂₋₃₀ alkynyl group; a C₁₋₃₀ alkoxy group; a C₆₋₃₀ aryloxy group; a C₁₋₃₀ hydroxyacryl group; a C₁₋₃₀ hydroxymethaacryl group; a fluorenyl group; a carbonyl group; an ether group; a carboxyl group; or a C₁₋₃₀ alkoxycarbonyl group; or the neighboring groups of Rₐ to R_{c} form a ring,
2) C₁ and C₂ are carbon; the double dotted line connecting C₁ and C₂ is a single bond or double bond,
3) when the double dotted line connecting C₁ and C₂ is a single bond, o and p are each independently an integer of 1 or 2; and when the double dotted line connecting C₁ and C₂ is a double bond, o and p are each an integer of 1;
4) C₃ is carbon or a direct bond of C₂-B₂,
5) when C₃ is carbon, q is an integer of 1 or 2,
6) the dotted line connecting B₁ and B₂ indicates that the bond is absent or is a single bond,
7) when the bond of the dotted line connecting B₁ and B₂ above is absent, B₁ is hydrogen; deuterium; a hydroxy group; a C₆₋₃₀ aryl group; a C₂₋₃₀ heterocyclic group comprising at least one heteroatom among O, N, S, Si, and P; a fused ring group of a C₆₋₃₀ aliphatic ring and a C₆₋₃₀ aromatic ring; a C₁₋₂₀ alkyl group; a C₂₋₂₀ alkenyl group; a C₂₋₂₀ alkynyl group; a C₁₋₂₀ alkoxy group; a C₆₋₃₀ aryl group; a C₁₋₂₀ hydroxyacryl group; a C₁₋₂₀ hydroxymethaacryl group; a fluorenyl group; a carbonyl group; an ether group; a carboxyl group; or a C₁₋₂₀ alkoxycarbonyl group; and B₂ is carbon connected to a polyimide-based repeating unit,
8) when the dotted line connecting B₁ and B₂ above is a single bond, B₁ is nitrogen connected to the polyimide-based repeating unit; and B₂ is carbon, and
9) the rings formed by binding between Rₐ to R_{c} and neighboring groups are each further substituted with one or more substituents selected from the group consisting of deuterium; a halogen; a silane group substituted or unsubstituted with a C₁₋₃₀ alkyl group or C₆₋₃₀ aryl group; a siloxane group; a boron group; a germanium group; a cyano group; an amino group; a nitro group; a C₁₋₃₀ alkylthio group; a C₁₋₃₀ alkoxy group; a C₆₋₃₀ arylalkoxy group; a C₁₋₃₀ alkyl group; a C₂₋₃₀ alkenyl group; a C₂₋₃₀ alkynyl group; a C₆₋₃₀ aryl group; a C₆₋₃₀ aryl group substituted with deuterium; a fluorenyl group; a C₂₋₃₀ heterocyclic group comprising at least one heteroatom among O, N, S, Si, and P; a C₃₋₃₀ alicyclic group; a C₇₋₃₀ arylalkyl group; a C₈₋₃₀ arylalkenyl group; and a combination thereof; or form a ring between neighboring substituents.

It is preferable that the compound represented by Formula Q above include compounds represented by Formulas Q-1 to Q-6. 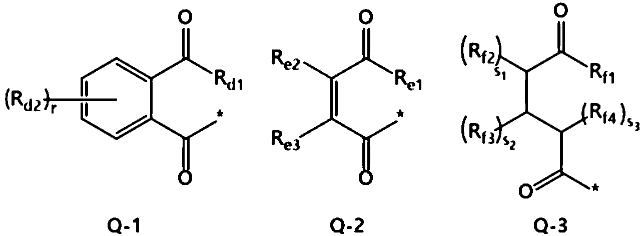 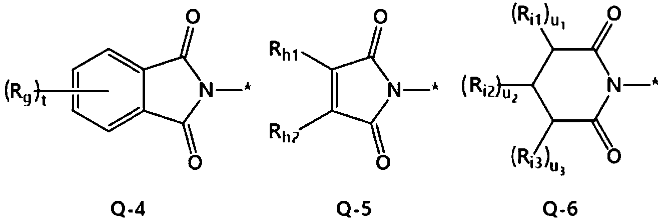 In Formulas Q-1 to Q-6 above,
1) R_{d1}, R_{d2}, Rₑ₁ to Rₑ₃, R_{f1} to R_{f4}, R_{g}, Rₕ₁, Rₕ₂,, and Rᵢ₁ to Rᵢ₃ are each independently hydrogen; deuterium; a hydroxy group; a C₆₋₃₀ aryl group; a C₂₋₃₀ heterocyclic group comprising at least one heteroatom among O, N, S, Si, and P; a fused ring group of a C₆₋₃₀ aliphatic ring and a C₆₋₃₀ aromatic ring; a C₁₋₃₀ alkyl group; a C₂₋₃₀ alkenyl group; a C₂₋₃₀ alkynyl group; a C₁₋₃₀ alkoxy group; a C₆₋₃₀ aryloxy group; a C₁₋₃₀ hydroxyacryl group; a C₁₋₃₀ hydroxymethaacryl group; a fluorenyl group; a carbonyl group; an ether group; a carboxyl group; or a C₁₋₃₀ alkoxycarbonyl group;
2) r and t are an integer of 0 to 4, and
3) s₁, s₂, and u₁ to u₃ are each independently an integer of 1 or 2.

It is preferable that the repeating unit of the polyimide-based precursor be prepared from a diamine monomer; a dianhydride monomer; and an anhydride monomer.

It is preferable that the weight average molecular weight of the polyimide-based precursor be 5,000 g/mol to 40,000 g/mol.

In another specific embodiment of the present disclosure, it is preferable that the negative photosensitive composition according to the present disclosure further include a reactive unsaturated compound; a solvent; and other additives.

It is preferable that the initiator be included in an amount of 0.01 wt% to 10 wt% based on the total amount of the composition.

It is preferable that the polyimide-based precursor be included in an amount of 5 wt% to 50 wt% based on the total amount of the composition.

It is preferable that the solvent be included in an amount of 50 wt% to 95 wt% based on the total amount of the composition.

In another specific embodiment of the present disclosure, it is preferable that the film prepared from the negative photosensitive composition be provided.

In another specific embodiment of the present disclosure, it is preferable that a semiconductor device or display device prepared using the film be provided.

In another specific embodiment of the present disclosure, it is preferable that an electronic device including the display device or display device and a control unit for driving the same.

### ADVANTAGEOUS EFFECTS

According to the present disclosure, it is possible to provide a photosensitive composition that leaves no residue after development by introducing a monomer containing a reactive functional group at the terminal of a polyimide-based precursor or copolymer resin and applying an oxime ester-based initiator, and a display device or semiconductor device prepared using the same.

### DETAILED DESCRIPTION

Hereinafter, some embodiments of the present disclosure will be described in detail with reference to exemplary drawings. In adding reference numerals to components of each drawing, the same components may have the same reference numerals as far as possible even though they are indicated in different drawings.

When it is determined that a detailed description of a related known constitution or function may obscure the gist of the present disclosure in describing the present disclosure, the detailed description thereof may be omitted. When the expressions "includes", "has", "consisting of", *etc.* mentioned in this specification are used, other parts may be added unless "only" is used. When a component is expressed in the singular form, it may include a case in which the plural form is included unless otherwise explicitly stated.

In addition, in describing the components of the present disclosure, terms such as first, second, A, B, (a), (b), *etc.* may be used. Such terms are only for distinguishing the components from other components, and the essence, order, sequence, number, or *etc.* of the relevant components are not limited by the terms.

In the description of the positional relationship of the components, when two or more components are described as being "connected", "linked", or "fused", *etc.,* the two or more components may be directly "connected", "linked", or "fused", but it should be understood that the two or more components may also be "connected", "linked", or "fused" by way of a further "interposition" of a different component. Here, the different component may be included in any one or more of the two or more components that are to be "connected", "linked", or "fused" to each other.

In addition, when a component such as a layer, a film, a region, a plate, or *etc.* is described to be "on top" or "on" of another component, it should be understood that this may not only include a case where the component is "immediately on top of" another component, but also include a case where another component is disposed therebetween. In contrast, it should be understood that when a component is described to be "immediately on top of" another part, this may mean that there is not another part disposed therebetween.

In the description of the temporal flow relationship relating to the components, the operation method, or the preparation method, for example, when the temporal precedence or flow precedence is described by way of "after", "subsequently", "thereafter", "before", *etc.,* it may also include cases where the flow is not continuous unless terms such as "immediately" or "directly" are used.

Meanwhile, when the reference is made to numerical values or corresponding information for components, numerical values or corresponding information may be interpreted as including an error range that may occur due to various factors (*e.g*., process factors, internal or external shocks, noise, *etc*.) even if a separate explicit description is not present.

The terms used in this specification and the appended claims should not be construed as limited to their usual or dictionary meanings, but should be interpreted in a way that is consistent with the technical spirit of the present disclosure, based on the principle that the inventor may appropriately define the concept of a term in order to best describe his or her invention.

As used herein, the term "halo" or "halogen" includes fluorine (F), chlorine (Cl), bromine (Br), and iodine (I), unless otherwise specified.

As used herein, the term "alkyl" or "alkyl group" has 1 to 60 carbons linked by a single bond unless otherwise specified, and refers to a radical of a saturated aliphatic functional group, including a linear chain alkyl group, a branched chain alkyl group, a cycloalkyl (alicyclic) group, an alkyl-substituted cycloalkyl group, and a cycloalkyl-substituted alkyl group.

As used herein, the term "haloalkyl group" or "halogenalkyl group" refers to an alkyl group in which a halogen is substituted, unless otherwise specified.

As used herein, the term "alkenyl" or "alkynyl" has a double bond or a triple bond, respectively, includes a linear or branched chain group, and has 2 to 60 carbon atoms, unless otherwise specified, but is not limited thereto.

As used herein, the term "cycloalkyl" refers to an alkyl which forms a ring having 3 to 60 carbon atoms unless otherwise specified, but is not limited thereto.

As used herein, the term "an alkoxy group" or "alkyloxy group" refers to an alkyl group to which an oxygen radical is linked, and has 1 to 60 carbon atoms unless otherwise specified, but is not limited thereto.

As used herein, the term "alkenoxyl group", "alkenoxy group", "alkenyloxyl group", or "alkenyloxy group" refers to an alkenyl group to which an oxygen radical is linked, and has 2 to 60 carbon atoms unless otherwise specified, but is not limited thereto.

As used herein, the terms "aryl group" and "arylene group" each have 6 to 60 carbon atoms unless otherwise specified, but are not limited thereto. As used herein, the aryl group or arylene group includes monocyclic compounds, ring assemblies, multiple fused cyclic compounds, *etc.* For example, the aryl group may include a phenyl group, a monovalent functional group of biphenyl, a monovalent functional group of naphthalene, a fluorenyl group, and a substituted fluorenyl group, and the arylene group may include a fluorenylene group and a substituted fluorenylene group.

As used herein, the term "ring assemblies" means that two or more ring systems (monocyclic or fused ring systems) are directly connected to each other through a single bond or double bond, and the number of direct links between such rings is one less than the total number of ring systems contained in the compound. In the ring assemblies, the same or different ring systems may be directly connected to each other through a single bond or double bond.

As used herein, since the aryl group includes ring assemblies, the aryl group includes biphenyl and terphenyl in which a benzene ring, which is a single aromatic ring, is connected by a single bond. In addition, since the aryl group also includes a compound in which an aromatic ring system fused to a single aromatic ring is connected by a single bond, it also includes, for example, a compound in which a benzene ring (which is a single aromatic ring) and fluorine (which is a fused aromatic ring system) are linked by a single bond.

As used herein, the term "multiple fused ring system" refers to a fused ring form in which at least two atoms are shared, and it includes a form in which ring systems of two or more hydrocarbons are fused, a form in which at least one heterocyclic system including at least one heteroatom is fused, *etc.* Such a multiple fused ring system may be an aromatic ring, a heteroaromatic ring, an aliphatic ring, or a combination of these rings. For example, in the case of an aryl group, it may be a naphthalenyl group, a phenanthrenyl group, a fluorenyl group, *etc.,* but is not limited thereto.

As used herein, the term "a spiro compound" has "a spiro union", and the spiro union refers to a linkage in which two rings are formed by sharing only one atom. At this time, the atom shared by the two rings is called a "spiro atom", and they are each called "monospiro-", "dispiro-", and "trispiro-" compounds depending on the number of spiro atoms included in a compound.

As used herein, the terms "fluorenyl group", "fluorenylene group", and "fluorenetriyl group" refer to a monovalent, divalent, or trivalent functional group in which R, R', R", and R‴ are all hydrogen in the following structures, respectively, unless otherwise specified; "substituted fluorenyl group", "substituted fluorenylene group", or "substituted fluorenetriyl group" means that at least one of the substituents R, R', R", and R‴ is a substituent other than hydrogen, and include cases where R and R' are bound to each other to form a spiro compound together with the carbon to which they are linked. As used herein, all of the fluorenyl group, the fluorenylene group, and the fluorenetriyl group may also be referred to as a fluorene group regardless of valences such as monovalent, divalent, trivalent, *etc.*

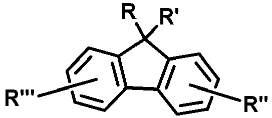

In addition, R, R', R", and R‴ may each independently be an alkyl group having 1 to 20 carbon atoms, an alkenyl group having 1 to 20 carbon atoms, an aryl group having 6 to 30 carbon atoms, and a heterocyclic group having 2 to 30 carbon atoms and, for example, the aryl group may be phenyl, biphenyl, naphthalene, anthracene, or phenanthrene, and the heterocyclic group may be pyrrole, furan, thiophene, pyrazole, imidazole, triazole, pyridine, pyrimidine, pyridazine, pyrazine, triazine, indole, benzofuran, quinazoline, or quinoxaline. For example, the substituted fluorenyl group and the fluorenylene group may each be a monovalent functional group or divalent functional group of 9,9-dimethylfluorene, 9,9-diphenylfluorene, and 9,9'-spirobi[9H-fluorene].

As used herein, the term "heterocyclic group" includes not only an aromatic ring such as "heteroaryl group" or "heteroarylene group", but also a non-aromatic ring, and refers to a ring having 2 to 60 carbon atoms each including one or more heteroatoms unless otherwise specified, but is not limited thereto. The term used in this application "heteroatom" refers to N, O, S, P, or Si unless otherwise specified, and a heterocyclic group refers to a monocyclic group including a heteroatom, ring assemblies, multiple fused ring systems, spiro compounds, *etc.*

For example, the "heterocyclic group" may include a compound including a heteroatom group (*e.g.,* SO₂, P=O, *etc.*)*,* such as the compound shown below, instead of carbon that forms a ring.

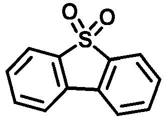

As used herein, the term "ring" includes monocyclic and polycyclic rings, and includes heterocycles containing at least one heteroatom as well as hydrocarbon rings, and includes aromatic and non-aromatic rings.

As used herein, the term "polycyclic" includes ring assemblies (*e.g.*, biphenyl, terphenyl, *etc.*), fused multiple ring systems, and spiro compounds, includes non-aromatic as well as aromatic compounds, and includes heterocycles containing at least one heteroatom as well as hydrocarbon rings.

As used herein, the term "alicyclic group" refers to cyclic hydrocarbons other than aromatic hydrocarbons, and it includes monocyclic, ring assemblies, fused multiple ring systems, spiro compounds, *etc.,* and refers to a ring having 3 to 60 carbon atoms unless otherwise specified, but is not limited thereto. For example, when benzene (*i.e.,* an aromatic ring) and cyclohexane (*i.e.,* a non-aromatic ring) are fused, it also corresponds to an aliphatic ring.

Additionally, when prefixes are named consecutively, it means that the substituents are listed in the order they are described. For example, in the case of an arylalkoxy group, it means an alkoxy group substituted with an aryl group; in the case of an alkoxycarbonyl group, it means a carbonyl group substituted with an alkoxy group; additionally, in the case of an arylcarbonyl alkenyl group, it means an alkenyl group substituted with an arylcarbonyl group, in which the arylcarbonyl group is a carbonyl group substituted with an aryl group.

Additionally, unless otherwise specified, the term "substituted" in the expression "substituted or unsubstituted" as used herein refers to a substitution with one or more substituents selected from the group consisting of deuterium, a halogen, an amino group, a nitrile group, a nitro group, a C₁-₃₀ alkyl group, a C₁-₃₀ alkoxy group, a C₁-₃₀ alkylamine group, a C₁-₃₀ alkylthiophene group, a C₆-₃₀ arylthiophene group, a C₂-₃₀ alkenyl group, a C₂-₃₀ alkynyl group, a C₃-₃₀ cycloalkyl group, a C₆-₃₀ aryl group, a C₆-₃₀ aryl group substituted with deuterium, a C₈-₃₀ arylalkenyl group, a silane group, a boron group, a germanium group, and a C₂₋₃₀ heterocyclic group containing at least one heteroatom selected from the group consisting of O, N, S, Si, and P, but is not limited to these substituents.

As used herein, the "names of functional groups" corresponding to the aryl group, arylene group, heterocyclic group, *etc.* exemplified as examples of each symbol and a substituent thereof may be described as "a name of the functional group reflecting its valence", and may also be described as the "name of its parent compound". For example, in the case of "phenanthrene", which is a type of an aryl group, the names of the groups may be described such that the monovalent group as "phenanthryl (group)", and the divalent group as "phenanthrylene (group)", *etc.,* but may also be described as "phenanthrene", which is the name of its parent compound, regardless of its valence.

Similarly, in the case of pyrimidine as well, it may be described as "pyrimidine" regardless of its valence, or it may also be described as the "name of the group" of the relevant valence such as pyrimidinyl (group) in the case of monovalent and pyrimidinylene (group) in the case of divalent. Therefore, when the type of a substituent in this application is described as the name of its parent compound, it may refer to an n-valent "group" formed by detachment of a hydrogen atom bonded to a carbon atom and/or hetero atom of its parent compound.

In addition, in describing the names of the compounds or the substituents in the present specification, the numbers, alphabets, *etc.* indicating positions may be omitted. For example, pyrido[4,3-d]pyrimidine may be described as pyridopyrimidine; benzofuro[2,3-d]pyrimidine as benzofuropyrimidine; 9,9-dimethyl-9H-fluorene as dimethyl fluorene, *etc.* Therefore, both benzo[g]quinoxaline and benzo[f]quinoxaline may be described as benzoquinoxaline.

In addition, unless there is an explicit description, the formulas used in this application are applied in the same manner as in the definition of substituents by the exponent definition of the formula below.

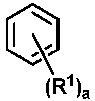

In particular, when a is an integer of 0, it means that the substituent R¹ is absent, that is, when a is 0, it means that all hydrogens are linked to carbons that form a benzene ring, and in this case, the formula or compound may be described while omitting the indication of the hydrogen linked to the carbon. In addition, when a is an integer of 1, one substituent R¹ may be linked to any one of the carbons forming a benzene ring; when a is an integer of 2 or 3, it may be linked, for example, as shown below; even when a is an integer of 4 to 6, it may be linked to the carbon of a benzene ring in a similar manner; and when a is an integer of 2 or greater, R¹ may be the same as or different from each other.

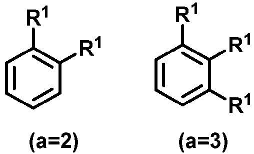

Unless otherwise specified in the present application, forming a ring means that neighboring groups bind to one another to form a single ring or fused multiple ring, and the single ring and the formed fused multiple ring include a heterocycle containing at least one heteroatom as well as a hydrocarbon ring, and may include aromatic and non-aromatic rings.

In addition, unless otherwise specified in the present specification, when indicating a condensed ring, the number in "number-condensed ring" indicates the number of rings to be condensed. For example, a form in which three rings are condensed with one another (*e.g.,* anthracene, phenanthrene, benzoquinazoline, *etc.*) may be expressed as a 3-condensed ring.

Meanwhile, as used herein, the term "bridged bicyclic compound" refers to a compound in which two rings share 3 or more atoms to form a ring unless otherwise specified. At this time, the shared atoms may include carbon or a hetero atom.

Hereinafter, embodiments of the present disclosure will be described in detail. However, these embodiments are provided for illustrative purposes, and the present disclosure is not limited thereby, and the present disclosure is only defined by the scope of the claims to be described later.

The negative photosensitive resin composition according to one embodiment of the present disclosure, which includes a polyimide-based precursor or a copolymer, may be used to prepare an insulating film, a surface protection film, and a redistribution layer of a semiconductor device; and a pixel defining layer (PDL) of a display device.

In preparing the negative photosensitive composition according to one embodiment of the present disclosure for application in a semiconductor device or display device, the following additives may be additionally included.

As an additive that may be added according to one embodiment of the present disclosure, a surface leveling agent may be additionally included to make the thickness of the coating film constant when coating the substrate. In order to uniformly coat according to the characteristics of the substrate surface, a surfactant may be additionally included, and in order to control the adhesive strength to the substrate surface, a silane-based coupling agent may be additionally included. A crosslinking agent may be additionally included to strengthen the binding between polymer molecules during the heat treatment step.

The components constituting a negative-type photosensitive composition are as follows.

### (1) Initiator

An oxime ester-based initiator should be used in order to implement a negative pattern with photolithography.

The oxime ester-based initiator commonly used in photosensitive resin compositions and preferably has a structure represented by the following Formula I.

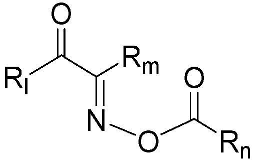

In Formula I above,
Rₗ to Rₙ are each independently selected from the group consisting of hydrogen; deuterium; a C₁₋₃₀ alkyl group; a C₁₋₃₀ alkylene group; a C₂-C₂₀ alkenyl group; a C₂-C₂₀ alkynyl group; a C₃₋₃₀ cycloalkyl group; a C₂₋₃₀ Alkylcycloalkyl group; a C₆₋₃₀ aryl group; a fused ring group of a C₆₋₃₀ aliphatic ring and a C₆₋₃₀ aromatic ring; a C₂₋₃₀ alkenyl group; a C₂₋₃₀ alkynyl group; a C₁₋₃₀ alkoxy group; a C₆₋₃₀ aryloxy group; a carbonyl group; an ether group; and a combination thereof.
Rₗ to Rₙ may each be independently further substituted with one or more substituents selected from the group consisting of hydrogen; deuterium; a C₁₋₃₀ alkyl group; a C₁₋₃₀ alkylene group; a C₂-C₂₀ alkenyl group; a C₂-C₂₀ alkynyl group; a C₃₋₃₀ cycloalkyl group; a C₂₋₃₀ Alkylcycloalkyl group; a C₆₋₃₀ aryl group; a fused ring group of a C₆₋₃₀ aliphatic ring and a C₆₋₃₀ aromatic ring; a C₂₋₃₀ alkenyl group; a C₂₋₃₀ alkynyl group; a C₁₋₃₀ alkoxy group; a C₆₋₃₀ aryloxy group; a carbonyl group; an ether group; and a combination thereof, or form a ring between neighboring substituents.

It is more preferable that the compound of Formula I above include Formula J below.

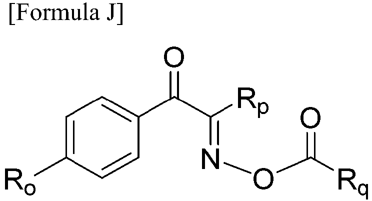

In Formula J above,
Rₒ is hydrogen or a C₁₋₁₀ alkyl group,
Rₚ to R_{q} are each independently selected from the group consisting of hydrogen; deuterium; a C₁₋₃₀ alkyl group; a C₁₋₃₀ alkylene group; a C₂-C₂₀ alkenyl group; a C₂-C₂₀ alkynyl group; a C₃₋₃₀ cycloalkyl group; a C₂₋₃₀ alkylcycloalkyl group; a C₆₋₃₀ aryl group; a fused ring group of a C₆₋₃₀ aliphatic ring and a C₆₋₃₀ aromatic ring; a C₂₋₃₀ alkenyl group; a C₂₋₃₀ alkynyl group or a C₁₋₃₀ alkoxy group; a carbonyl group; an ether group; and a combination thereof
Rₚ to R_{q} may each be independently further substituted with one or more substituents selected from the group consisting of hydrogen; deuterium; a C₁₋₃₀ alkyl group; a C₁₋₃₀ alkylene group; a C₂-C₂₀ alkenyl group; a C₂-C₂₀ alkynyl group; a C₃₋₃₀ cycloalkyl group; a C₂₋₃₀ alkylcycloalkyl group; a C₆₋₃₀ aryl group; a fused ring group of a C₆₋₃₀ aliphatic ring and a C₆₋₃₀ aromatic ring; a C₂₋₃₀ alkenyl group; a C₂₋₃₀ alkynyl group; a C₁₋₃₀ alkoxy group; a C₆₋₃₀ aryloxy group; a carbonyl group; an ether group; and a combination thereof, or form a ring between neighboring substituents.

It is preferable that the compound of Formula I above be selected from Formulas I-1 to I-60 below.

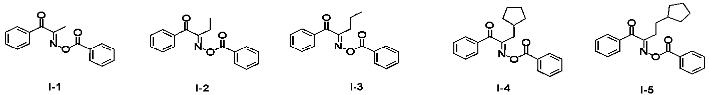

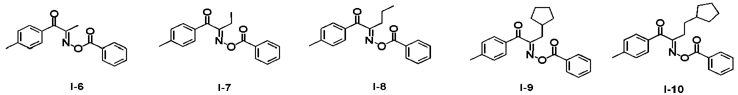

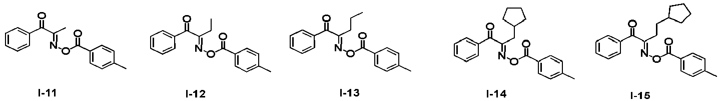

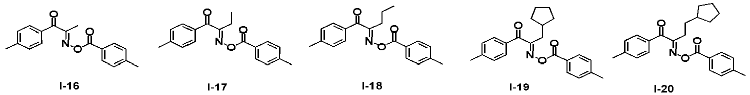

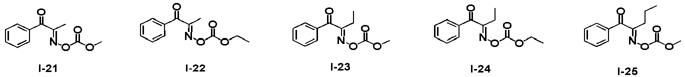

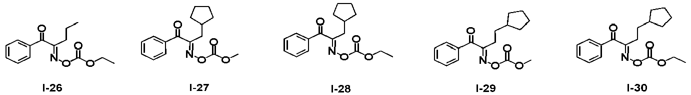

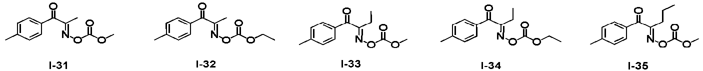

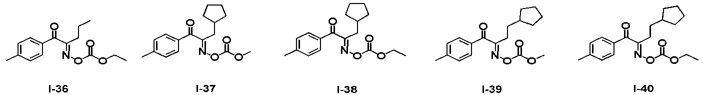

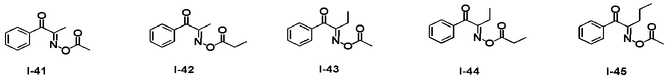

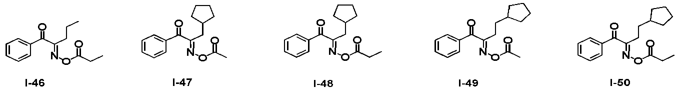

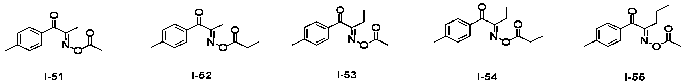

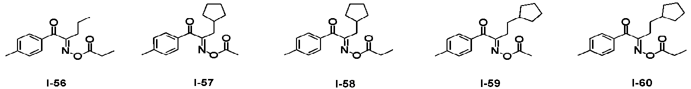

It is preferable that the polyimide-based precursor include a polyimide repeating unit; and a reactive terminal group represented by the following Formula Q that is bonded to the terminal end of the polyimide-based repeating unit.

The oxime ester-based initiator may be used together with a photosensitizer that causes a chemical reaction by absorbing light to enter an excited state and then transferring the energy. Examples of the photosensitizer may include tetraethylene glycol *bis*-3-mercaptopropionate, pentaerythritol tetrakis-3-mercaptopropionate, dipentaerythritol tetrakis-3-mercaptopropionate, *etc.*

The photoinitiator may be included in an amount of 0.01 wt% to 10 wt%, 0.01 wt% to 10 wt%; 0.1 wt% to 10 wt%; 0.5 wt% to 10 wt%; 0.01 wt% to 5 wt%; 0.1 wt% to 5 wt%; 0.5 wt% to 5 wt%; 0.01 wt% to 2 wt%; 0.1 wt% to 2 wt%; or 0.5 wt% to 2 wt%. When the photoinitiator is included within the above range, it is possible to obtain excellent reliability due to sufficient curing that occurs during exposure to light in the pattern forming process, thereby obtaining excellent heat resistance, light resistance, and chemical resistance of the pattern, and also obtaining excellent resolution and adhesion, and being capable of preventing a decrease in transmittance due to an unreacted initiator.

### (2) Polyimide-based Precursor

The patterning resin according to one embodiment of the present disclosure may include a polyimide-based precursor.

The polyimide-based precursor refers to a resin, which includes an amic acid-based copolymer that can be processed into a polyimide-based copolymer through chemical or thermal treatment, and a polyimide-based precursor (copolymer) that has undergone chemical or thermal treatment.

The polyimide-based precursor may be contained in an amount of 5 wt% to 50 wt%, preferably 10 wt% to 40 wt%, based on the total amount of the negative-type photosensitive composition.

The polyimide-based precursor may include the copolymers represented by Formula 1-1 and Formula 1-2 below, *etc.,* but are not limited thereto. These may be used alone or in combination of two or more.

It is more preferable that the repeating unit of the negative-type polyimide-based precursor according to the present disclosure include a repeating unit selected from the group consisting of Formula 1-1 and Formula 1-2 below, and a combination thereof. 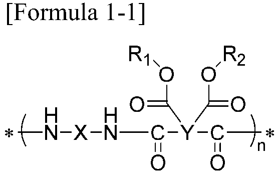 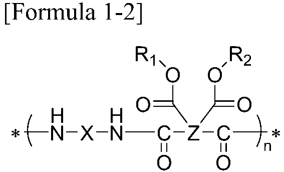 wherein in Formulas 1-1 and Formula 1-2 above,
1) * represents a repeating unit or a part where a bond is connected by a reactive end group represented by Formula Q of claim 2,
2) R₁ to R₄ are Formula 2 below,
3) X is Formula 3 below,
4) m and n are an integer of 1 to 1000, 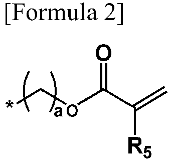 wherein in Formula 2 above,
5) * represents a part where a bond is connected,
6) a is an integer of 1 to 30,
7) R₅ is hydrogen or methyl,
8) Y is selected from the group consisting of a C₆-C₃₀ arylene group; a C₂₋₃₀ heterocyclic group comprising at least one heteroatom among O, N, S, Si, and P; a fused ring group of a C₆₋₃₀ aliphatic ring and a C₆₋₃₀ aromatic ring; a C₁₋₂₀ alkylene group; a C₁₋₂₀ cycloalkylene group; a C₂₋₂₀ alkenylene group; a C₃₋₂₀ cycloalkenylene group; a C₂₋₂₀ alkynylene group; a C₃₋₂₀ cycloalkynylene group; Formula 3; and a combination thereof,
9) Z is selected from the group consisting of a C₆-C₃₀ arylene group; a C₂₋₃₀ heterocyclic group comprising at least one heteroatom among O, N, S, Si, and P; a fused ring group of a C₆₋₃₀ aliphatic ring and a C₆₋₃₀ aromatic ring; a C₁₋₂₀ alkylene group; a C₁₋₂₀ cycloalkylene group; a C₂₋₂₀ alkenylene group; a C₃₋₂₀ cycloalkenylene group; a C₂₋₂₀ alkynylene group; a C₃₋₂₀ cycloalkynylene group; Formula 3; and a combination thereof, 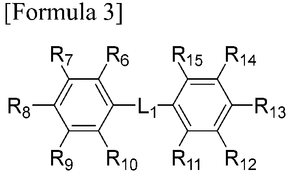
10) L₁ is selected from the group consisting of a single bond, -CH₂-, -CH₂CH₂-, - CH₂OCH₂-, -CH(CH₃)-, -C(CH₃)₂-, -O-, -CH(CF₃)-, -C(CF₃)₂-, -S-, -SO₂-, Si(CH₃)₂-, -C₆H₄-, - OC₆H₄0-, -CO-, -NHCO-, AND -COO-,
11) two of R₆ to R₁₅ are connection parts with an amide group of Formula 1-1 or Formula 1-2 above,
12) the remaining ones of R₆ to R₁₅ excluding the connection parts are each independently hydrogen; deuterium; a hydroxy group; a C₆₋₃₀ aryl group; a C₂₋₃₀ heterocyclic group comprising at least one heteroatom among O, N, S, Si, and P; a fused ring group of a C₆₋₃₀ aliphatic ring and a C₆₋₃₀ aromatic ring; a C₁-₂₀ alkyl group; a C₂-₂₀ alkenyl group; a C₂-₂₀ alkynyl group; a C₁-₂₀ alkoxy group; a C₆-₃₀ aryloxy group; a fluorenyl group; a carbonyl group; an ether group; a carboxyl group; a C₁-₂₀ alkoxycarbonyl group; or neighboring R₆ and R₁₅, and R₁₀ and R₁₁ form a ring, and
13) the rings formed by binding between Y, Z, R₆ to R₁₅, and neighboring groups are each further substituted with one or more substituents selected from the group consisting of deuterium; a halogen; a silane group substituted or unsubstituted with a C₁-₃₀ alkyl group or C₆-₃₀ aryl group; a siloxane group; a boron group; a germanium group; a cyano group; an amino group; a nitro group; a C₁₋₃₀ alkylthio group; a C₁₋₃₀ alkoxy group; a C₆₋₃₀ arylalkoxy group; a C₁₋₃₀ alkyl group; a C₂₋₃₀ alkenyl group; a C₂₋₃₀ alkynyl group; a C₆₋₃₀ aryl group; a C₆₋₃₀ aryl group substituted with deuterium; a fluorenyl group; a C₂₋₃₀ heterocyclic group comprising at least one heteroatom among O, N, S, Si, and P; a C₃₋₃₀ alicyclic group; a C₇₋₃₀ arylalkyl group; a C₈₋₃₀ arylalkenyl group; and a combination thereof; or form a ring between neighboring substituents.

It is preferable that the repeating unit of the polyimide-based precursor include in an end group thereof a reactive group represented by Formula Q below. 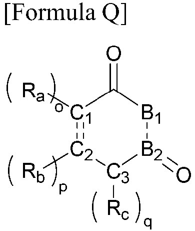 wherein in Formula Q above,
1) Rₐ to R_{c} are each independently hydrogen; deuterium; a hydroxy group; a C₆₋₃₀ aryl group; a C₂₋₃₀ heterocyclic group comprising at least one heteroatom among O, N, S, Si, and P; a fused ring group of a C₆₋₃₀ aliphatic ring and a C₆₋₃₀ aromatic ring; a C₁-₃₀ alkyl group; a C₂-₃₀ alkenyl group; a C₂-₃₀ alkynyl group; a C₁-₃₀ alkoxy group; a C₆₋₃₀ aryloxy group; a C₁₋₃₀ hydroxyacryl group; a C₁₋₃₀ hydroxymethaacryl group; a fluorenyl group; a carbonyl group; an ether group; a carboxyl group; or a C₁-₃₀ alkoxycarbonyl group; or the neighboring groups of Rₐ to R_{c} form a ring,
2) C₁ and C₂ are carbon; the double dotted line connecting C₁ and C₂ is a single bond or double bond,
3) when the double dotted line connecting C₁ and C₂ is a single bond, o and p are each independently an integer of 1 or 2; and when the double dotted line connecting C₁ and C₂ is a double bond, o and p are each an integer of 1;
4) C₃ is carbon or a direct bond of C₂-B₂,
5) when C₃ is carbon, q is an integer of 1 or 2,
6) the dotted line connecting B₁ and B₂ indicates that the bond is absent or is a single bond,
7) when the bond of the dotted line connecting B₁ and B₂ above is absent, B₁ is hydrogen; deuterium; a hydroxy group; a C₆₋₃₀ aryl group; a C₂₋₃₀ heterocyclic group comprising at least one heteroatom among O, N, S, Si, and P; a fused ring group of a C₆₋₃₀ aliphatic ring and a C₆₋₃₀ aromatic ring; a C₁-₂₀ alkyl group; a C₂-₂₀ alkenyl group; a C₂-₂₀ alkynyl group; a C₁-₂₀ alkoxy group; a C₆₋₃₀ aryl group; a C₁₋₂₀ hydroxyacryl group; a C₁₋₂₀ hydroxymethaacryl group; a fluorenyl group; a carbonyl group; an ether group; a carboxyl group; or a C₁-₂₀ alkoxycarbonyl group; and B₂ is carbon connected to a polyimide-based repeating unit,
8) when the dotted line connecting B₁ and B₂ above is a single bond, B₁ is nitrogen connected to the polyimide-based repeating unit; and B₂ is carbon, and
9) the rings formed by binding between Rₐ to R_{c} and neighboring groups are each further substituted with one or more substituents selected from the group consisting of deuterium; a halogen; a silane group substituted or unsubstituted with a C₁-₃₀ alkyl group or C₆-₃₀ aryl group; a siloxane group; a boron group; a germanium group; a cyano group; an amino group; a nitro group; a C₁₋₃₀ alkylthio group; a C₁₋₃₀ alkoxy group; a C₆₋₃₀ arylalkoxy group; a C₁₋₃₀ alkyl group; a C₂₋₃₀ alkenyl group; a C₂₋₃₀ alkynyl group; a C₆₋₃₀ aryl group; a C₆₋₃₀ aryl group substituted with deuterium; a fluorenyl group; a C₂₋₃₀ heterocyclic group comprising at least one heteroatom among O, N, S, Si, and P; a C₃₋₃₀ alicyclic group; a C₇₋₃₀ arylalkyl group; a C₈₋₃₀ arylalkenyl group; and a combination thereof; or form a ring between neighboring substituents.

It is preferable that the reactive end group represented by Formula Q above include compounds represented by Formulas Q-1 to Q-6. 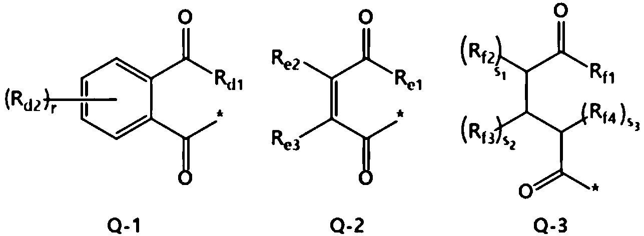 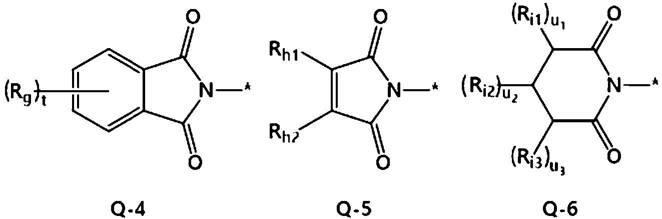 wherein in Formulas Q-1 to Q-6 above,
1) R_{d1}, R_{d2}, Rₑ₁ to Rₑ₃, R_{f1} to R_{f4}, R_{g}, Rₕ₁, Rₕ₂,, and Rᵢ₁ to Rᵢ₃ are each independently hydrogen; deuterium; a hydroxy group; a C₆₋₃₀ aryl group; a C₂₋₃₀ heterocyclic group comprising at least one heteroatom among O, N, S, Si, and P; a fused ring group of a C₆₋₃₀ aliphatic ring and a C₆₋₃₀ aromatic ring; a C₁-₃₀ alkyl group; a C₂-₃₀ alkenyl group; a C₂-₃₀ alkynyl group; a C₁-₃₀ alkoxy group; a C₆-₃₀ aryloxy group; a C₁₋₃₀ hydroxyacryl group; a C₁₋₃₀ hydroxymethaacryl group; a fluorenyl group; a carbonyl group; an ether group; a carboxyl group; or a C₁-₃₀ alkoxycarbonyl group;
2) r and t are an integer of 0 to 4, and
3) s₁, s₂, and u₁ to u₃ are each independently an integer of 1 or 2.

The weight average molecular weight of the polyimide-based precursor may be 5,000 g/mol to 40,000 g/mol, preferably 5,000 g/mol to 30,000 g/mol, and more preferably 6,000 g/mol to 25,000 g/mol. When the weight average molecular weight of the polyimide-based precursor is within the above range, no residue of the exposed layer remains during development, and the loss of film thickness of the non-exposed layer is minimized, and thus a good pattern can be obtained. The polyimide-based precursor may be contained in an amount of 5 wt% to 50 wt%, and more preferably 15 wt% to 45 wt%, based on the total amount of the photosensitive composition. When the polyimide-based precursor is contained within the above range, a constant film thickness can be obtained in the coating step, and excellent sensitivity, developability, and adhesion (an adherent property) can be obtained.

### (3) Reactive unsaturated compound

The reactive unsaturated compound, which is essentially necessary for a negative pattern, has an ethylenically unsaturated double bond; therefore, it is possible to form a pattern having excellent heat resistance, light resistance, and chemical resistance by causing sufficient polymerization during exposure to light in the pattern forming process.

Specific examples of the reactive unsaturated compound may be ethylene glycol diacrylate, ethylene glycol dimethacrylate, diethylene glycol diacrylate, triethylene glycol diacrylate, triethylene glycol dimethacrylate, 1,6-hexanediol diacrylate, 1,6-hexanediol dimethacrylate, pentaerythritol triacrylate, dipentaerythritol pentaacrylate, dipentaerythritol hexaacrylate, bisphenol A epoxy acrylate, ethylene glycol monomethyl ether acrylate, trimethylolpropane triacrylate, tripentaerythritol octaacrylate, *etc.*

Examples of commercially available products of the reactive unsaturated compound are as follows.

Examples of the bifunctional ester of (meth)acrylic acid may include Aronix M-210, M-240, M-6200, *etc.* (Toa Kosei Kagaku Kogyo Co., Ltd.), KAYARAD HDDA, HX-220, R-604, *etc.* (Nippon Kayaku Co., Ltd.), and V-260, V-312, V-335 HP, *etc.* (Osaka Yuki Kagaku Kogyo Co., Ltd.).

Examples of the trifunctional ester of (meth)acrylic acid include M-309, M-400, M-405, M-450, M-7100, M-8030, M-8060, *etc.* (Toa Kosei Kagaku Kogyo Co., Ltd.), KAYARAD TMPTA, DPCA-20, DPCA-60, DPCA-120, *etc.* (Nippon Kayaku Co., Ltd.), and V-295, V-300, V-360, *etc.* (Osaka Yuki Kagaku Kogyo Co., Ltd.).

These products may be used alone or in combination of two or more.

The reactive unsaturated compound may be used after treating with an acid anhydride so as to provide improved developability. The reactive unsaturated compound may be included in an amount of 1 wt% to 40 wt%, for example, 1 wt% to 20 wt%, based on the total amount of the photosensitive composition. When the reactive unsaturated compound is included within the above range, sufficient curing occurs during exposure to light in the pattern forming process, thus obtaining excellent reliability, excellent heat resistance, light resistance, and chemical resistance of the pattern, and also excellent resolution and adhesion.

### (4) Solvent

As the solvent, those materials which are compatible with the polyimide-based precursor or copolymer resin, the photosensitive agent, and the pigments, but do not react with them may be used.

Examples of the solvent include alcohols such as methanol, ethanol, *etc.;* ethers such as dichloroethyl ether, *n-*butyl ether, diisoamyl ether, methylphenyl ether, tetrahydrofuran, *etc.;* glycol ethers such as ethylene glycol monomethyl ether, ethylene glycol monoethyl ether, *etc.;* cellosolve acetates such as methyl cellosolve acetate, ethyl cellosolve acetate, diethyl cellosolve acetate, *etc.;* carbitols such as methylethyl carbitol, diethyl carbitol, diethylene glycol monomethyl ether, diethylene glycol monoethyl ether, diethylene glycol dimethyl ether, diethylene glycol methyl ethyl ether, diethylene glycol diethyl ether, *etc.;* propylene glycol alkyl ether acetates such as propylene glycol methyl ether acetate, propylene glycol propyl ether acetate, *etc.;* aromatic hydrocarbons such as toluene, xylene, *etc.;* ketones such as methyl ethyl ketone, cyclohexanone, 4-hydroxy-4-methyl-2-pentanone, methyl-*n*-propyl ketone, methyl-*n*-butyl ketone, methyl-*n*-amyl ketone, 2-heptanone, *etc.;* saturated aliphatic monocarboxylic acid alkyl esters such as ethyl acetate, *n*-butyl acetate, isobutyl acetate, *etc.;* lactic acid esters such as methyl lactate, ethyl lactate, *etc.;* oxyacetic acid alkyl esters such as methyl oxyacetate, ethyl oxyacetate, butyl oxyacetate, *etc.;* alkoxy acetate alkyl esters such as methoxy methyl acetate, methoxy ethyl acetate, methoxy butyl acetate, ethoxy methyl acetate, ethoxy ethyl acetate, *etc.;* 3-oxypropionic acid alkyl esters such as 3-oxy methyl propionate, 3-oxy ethyl propionate, *etc.;* 3-alkoxy propionic acid alkyl esters such as 3-methoxy methyl propionate, 3-methoxy ethyl propionate, 3-ethoxy ethyl propionate, 3-ethoxy methyl propionate, *etc.;* 2-oxypropionic acid alkyl esters such as methyl 2-oxypropionate, ethyl 2-oxypropionate, propyl 2-oxypropionate, *etc.;* 2-alkoxy propionic acid alkyl esters such as 2-methoxy methyl propionate, 2-methoxy ethyl propionate, 2-ethoxy ethyl propionate, 2-ethoxy methyl propionate, *etc.;* monooxy monocarboxylic acid alkyl esters of 2-oxy-2-methyl propionic acid esters such as 2-oxy-2-methyl methyl propionate, 2-oxy-2-methyl ethyl propionate, *etc.,* and 2-alkoxy-2-methyl propionic acid alkyls such as 2-methoxy-2-methyl methyl propionate, 2-ethoxy-2-methyl ethyl propionate, *etc.;* esters such as 2-hydroxyethyl propionate, 2-hydroxy-2-methyl ethyl propionate, ethyl hydroxyacetate, 2-hydroxy-3-methyl methyl butanoate, *etc.;* and ketonic acid esters such as ethyl pyruvate, *etc.*

Further, high-boiling point solvents such as *N*-methylformamide, *N,N-*dimethylformamide, *N*-methylformanilide, *N*-methylacetamide, *N,N*-dimethylacetamide, *N-*methylpyrrolidone, dimethyl sulfoxide, benzyl ethyl ether, dihexyl ether, acetylacetone, isophorone, caproic acid, caprylic acid, 1-octanol, 1-nonanol, benzyl alcohol, benzyl acetate, ethyl benzoate, diethyl oxalate, diethyl maleate, γ-butyrolactone, ethylene carbonate, propylene carbonate, and phenyl cellosolve acetate may also be used.

Considering compatibility and reactivity, among the above solvents, glycol ethers such as ethylene glycol monoethyl ether, *etc.;* ethylene glycol alkyl ether acetates such as ethyl cellosolve acetate, *etc.;* esters such as ethyl 2-hydroxypropionate, *etc.;* carbitols such as diethylene glycol monomethyl ether, *etc.*); and propylene glycol alkyl ether acetates such as propylene glycol methyl ether acetate, propylene glycol propyl ether acetate, *etc.* may be used.

The solvent may be contained as a balance amount based on the total amount of the photosensitive composition, and specifically in an amount of 50 wt% to 95 wt%, 50 wt% to 90 wt%, 50 wt% to 85 wt%, and 50 wt% to 75 wt%. When the solvent is contained within the above range, the processability when preparing the pattern layer is excellent as the negative-type photosensitive resin composition has an appropriate viscosity.

### (5) Other additives

In order to prevent stains or spots during application, to improve leveling performance, and to prevent the generation of residues due to non-development, the negative photosensitive resin composition may further include additives, such as malonic acid; 3-amino-1,2-propanediol; a silane-based coupling agent containing a vinyl group or (meth)acryloxy group; a surface leveling agent; a surfactant; a crosslinker; *etc.*

For example, the photosensitive resin composition may further include a silane-based coupling agent having a reactive substituent such as a vinyl group, a carboxyl group, a methacryloxy group, an isocyanate group, an epoxy group, *etc.* in order to improve adhesion to a substrate, *etc.*

Examples of the silane-based coupling agent may include trimethoxysilyl benzoic acid, γ-methacryloxypropyl trimethoxysilane, vinyl triacetoxysilane, vinyl trimethoxysilane, γ-isocyanate propyl triethoxysilane, γ-glycidoxy propyl trimethoxy silane, β-epoxy cyclohexyl ethyl trimethoxy silane, and silane-based coupling agents of Shinetsu Silicon, which are commercially available under the names KBM-502, KBM-602, KBM-573, KBE-9007N, *etc.,* and these may be used alone or in a mixture of two or more.

The silane-based coupling agent may be contained in an amount of 0.01 parts by weight to 10 parts by weight based on 100 parts by weight of the photosensitive resin composition. When the silane-based coupling agent is contained within the above-described range, adhesion, storability, *etc.* are excellent.

In addition, the photosensitive resin composition may further include a surface leveling agent so as to form a constant film thickness in the coating step, if necessary.

The surface leveling agent to be used may include F-554^{®}, F-556^{®}, F-557^{®}, F-559^{®}, F-560^{®}, F-563^{®}, RS-72-K^{®}, R-40^{®}, R-41^{®}, R-43^{®}, *etc.* from DIC; Efka^{®} FL3740, Efka^{®} FL3741, Efka^{®} FL3745, Efka^{®} FL3770, *etc.* from BASF.

The surface leveling agent can be used in an amount of 0.001 to 5 parts by weight per 100 parts by weight of the photosensitive resin composition. When the surface leveling agent is included within the above-described range, coating uniformity can be secured and the film can be coated to have a constant thickness.

In addition, the photosensitive resin composition may further include a surfactant to improve coating properties and prevent defects, if necessary.

The surfactant to be used may include those commercially available under the names of: BM-1000^{®}, BM-1100^{®}, *etc.* from BM Chemie; Megaface F 142D^{®}, Megaface F 172^{®}, Megaface F 173^{®}, Megaface F 183^{®}, *etc.* from Dainippon Ink Kagaku Kogyo; Fluorad FC-135^{®}, Fluorad FC-170C^{®}, Fluorad FC-430^{®}, Fluorad FC-431^{®}, *etc.* from Sumitomo 3M; Saffron S-112^{®}, Saffron S-113^{®}, Saffron S-131^{®}, Saffron S-141^{®}, Saffron S-145^{®}, *etc.* from Asahi Glass; and SH-28PA^{®}, SH-190^{®}, SH-193^{®}, SZ-6032^{®}, SF-8428^{®}, *etc.* from Toray Silicone.

In addition, the photosensitive resin composition may further include a silicone-based surfactant as needed.

As the silicone-based surfactant, silicone-based surfactants commercially available under the names of S-101, S-201, S-301, S-601, S-701, S-801 RS-55, RS-56, *etc.* from DIC; EFKA^{®} 3030, EFKA^{®} 3034, EFKA^{®}3886, *etc.* from BASF; 3030, 3085, 3236, *etc.* fromAFCONA; BYK-378, BYK-3550, BYK-3751, BYK-3754, *etc.* from BYK can be used.

The surfactant may be used in an amount of 0.001 to 5 parts by weight based on 100 parts by weight of the photosensitive resin composition. When the surfactant is contained within the above-described range, coating uniformity can be secured, stains do not occur, and wetting to the glass substrate is excellent.

As the crosslinker, 1,4-bis(methoxymethyl)benzene, diethyl sulfate, 3-aminopropyltriethoxysilane, *N,N*'-methylenebis acrylamide, *etc.* may be used, and these may be used alone or in a mixture of two or more.

The crosslinker may be used in an amount of 0.001 to 5 parts by weight per 100 parts by weight of the photosensitive resin composition. When the crosslinker is included within the above-described range, it is advantageous in appropriately imparting physical properties, for example, mechanical properties (*e.g*., tensile strength) to the cured coating film.

In addition, a certain amount of other additives may be added to the photosensitive resin composition within a range that does not impair physical properties.

Hereinafter, Synthesis Examples and Examples according to the present disclosure will be described in detail, but Synthesis Examples and Examples of the present disclosure are not limited thereto.

### (Synthesis Example 1)

(Solution A) A 500 mL heat medium circulation-type jacket reactor was installed by attaching a stirrer, a nitrogen injection device, a dropping funnel, a temperature controller, and a cooler, charged with 141.87 g of N-methylpyrrolidone (NMP) while filling it with nitrogen. Then, 22.22 g of 3,3',4,4'-benzophenonetetracarboxylic anhydride was added thereto and the mixture was maintained at 25°C while stirring. 19.86 g of 4-hydroxybutyl acrylate was added thereto and allowed to react while slowly adding 11.17 g of pyridine thereto. Thereafter, while maintaining the internal temperature of the reactor at -10°C, a solution in which 35.54 g of N,N'-dicyclohexylcarbodiimide and 71.07 g of N-methylpyrrolidone (NMP) were mixed was slowly added dropwise and the mixture was stirred for 3 hours.

(Solution B) A 500 mL heat medium circulation-type jacket reactor was installed by attaching a stirrer, a nitrogen injection device, a dropping funnel, a temperature controller, and a cooler, and charged with and 62.09 g of N-methylpyrrolidone (NMP) while filling it with nitrogen. Then, 15 g of 3,3'-dimethylbenzidine was added thereto and stirred until it was completely dissolved, and 0.52 g of phthalic anhydride was added thereto and reacted for 5 hours, and the internal temperature was cooled to -10°C and maintained thereat.

(Polymerization Reaction) Solution A was added dropwise to Solution B, which was maintained at -10°C, using a metering pump while stirring for 1 hour. Then, the temperature was increased to 25°C over 1 hour, the reaction was maintained for 2 hours, and then the mixture was added dropwise to distilled water to precipitate. The thus-obtained solids were washed twice with distilled water and then dried under vacuum at 25°C for 48 hours to obtain powder of a copolymerized polyimide precursor.

### (Synthesis Example 2)

(Solution A) A 500 mL heat medium circulation-type jacket reactor was installed by attaching a stirrer, a nitrogen injection device, a dropping funnel, a temperature controller, and a cooler, charged with 141.87 g of N-methylpyrrolidone (NMP) while filling it with nitrogen. Then, 22.22 g of 3,3',4,4'-benzophenonetetracarboxylic anhydride was added thereto and the mixture was maintained at 25°C while stirring. 19.86 g of 4-hydroxybutyl acrylate was added thereto and allowed to react while slowly adding 11.17 g of pyridine thereto. Thereafter, while maintaining the internal temperature of the reactor at -10°C, a solution in which 35.54 g of N,N'-dicyclohexylcarbodiimide and 71.07 g of N-methylpyrrolidone (NMP) were mixed was slowly added dropwise and the mixture was stirred for 3 hours.

(Solution B) A 500 mL heat medium circulation-type jacket reactor was installed by attaching a stirrer, a nitrogen injection device, a dropping funnel, a temperature controller, and a cooler, and charged with and 61.58 g of N-methylpyrrolidone (NMP) while filling it with nitrogen. Then, 15 g of 3,3'-dimethylbenzidine was added thereto and stirred until it was completely dissolved, and 0.40 g of citraconic anhydride was added thereto and reacted for 5 hours, and the internal temperature was cooled to -10°C and maintained thereat.

(Polymerization Reaction) Solution A was added dropwise to Solution B, which was maintained at -10°C, using a metering pump while stirring for 1 hour. Then, the temperature was increased to 25°C over 1 hour, the reaction was maintained for 2 hours, and then the mixture was added dropwise to distilled water to precipitate. The thus-obtained solids were washed twice with distilled water and then dried under vacuum at 25°C for 48 hours to obtain powder of a copolymerized polyimide precursor.

### (Preparation Example 1) Preparation of negative photosensitive composition

14.88 g of the polyimide precursor obtained in Synthetic Examples 1 to 2, 0.45 g of PBG-304 (Tronly), 7.3 g of Miramer M600, 0.015 g of F-563 (DIC), 1.5 g of KBM-573 (Shinetsu Silicon), and 1.0 g of 1,4-bis(methoxymethyl)benzene were stirred along with 53.4 g of propylene glycol methyl ether acetate (PGMEA) at room temperature for 12 hours. Then, the composition was filtered three times to remove impurities, thereby preparing a photosensitive composition.

Photosensitive compositions were prepared with the compositions shown in Table 1 below.

**[Table 1]**

| | **Polyimide-based precursor / Content (wt%)** | **Oxime ester-based initiator / Content (wt%)** | **MIRAME R M600 Content (wt%)** | **F-563 Content (wt%)** | **KBM-573 Content (wt%)** | **1,4-Bis(metho xymethyl) benzene** | **Solvent (PGMEA) Content (wt%)** |
|---|---|---|---|---|---|---|---|
| **Example 1** | Synthesis Example 1/ 21.57 | I-1/ 0.75 | 6.25 | 0.02 | 1.99 | 1.20 | 68.22 |
| **Example 2** | Synthesis Example1/ 21.57 | I-3/ 0.75 | 6.25 | 0.02 | 1.99 | 1.20 | 68.22 |
| **Example 3** | Synthesis Example1/ 21.57 | I-5/ 0.75 | 6.25 | 0.02 | 1.99 | 1.20 | 68.22 |
| **Example 4** | Synthesis Example1/ 21.57 | I-6/ 0.75 | 6.25 | 0.02 | 1.99 | 1.20 | 68.22 |
| **Example 5** | Synthesis Example1/ 21.57 | I-9/ 0.75 | 6.25 | 0.02 | 1.99 | 1.20 | 68.22 |
| **Example 6** | Synthesis Example1/ 21.57 | I-11/ 0.75 | 6.25 | 0.02 | 1.99 | 1.20 | 68.22 |
| **Example 7** | Synthesis Example1/ 21.57 | I-13/ 0.75 | 6.25 | 0.02 | 1.99 | 1.20 | 68.22 |
| **Example 8** | Synthesis Example1/ 21.57 | I-15/ 0.75 | 6.25 | 0.02 | 1.99 | 1.20 | 68.22 |
| **Example 9** | Synthesis Example1/ 21.57 | I-16/ 0.75 | 6.25 | 0.02 | 1.99 | 1.20 | 68.22 |
| **Example 10** | Synthesis Example1/ 21.57 | I-17/ 0.75 | 6.25 | 0.02 | 1.99 | 1.20 | 68.22 |
| **Example 11** | Synthesis Example1/ 21.57 | I-20/ 0.75 | 6.25 | 0.02 | 1.99 | 1.20 | 68.22 |
| **Example 12** | Synthesis Examplel/ 21.57 | I-21/ 0.75 | 6.25 | 0.02 | 1.99 | 1.20 | 68.22 |
| **Example 13** | Synthesis Example1/ 21.57 | I-23/ 0.75 | 6.25 | 0.02 | 1.99 | 1.20 | 68.22 |
| **Example 14** | Synthesis Example1/ 21.57 | I-24/ 0.75 | 6.25 | 0.02 | 1.99 | 1.20 | 68.22 |
| **Example 15** | Synthesis Example2/ 21.57 | I-26/ 0.75 | 6.25 | 0.02 | 1.99 | 1.20 | 68.22 |
| **Example 16** | Synthesis Example2/ 21.57 | I-28/ 0.75 | 6.25 | 0.02 | 1.99 | 1.20 | 68.22 |
| **Example 17** | Synthesis Example2/ 21.57 | I-30/ 0.75 | 6.25 | 0.02 | 1.99 | 1.20 | 68.22 |
| **Example 18** | Synthesis Example2/ 21.57 | I-31/ 0.75 | 6.25 | 0.02 | 1.99 | 1.20 | 68.22 |
| **Example 19** | Synthesis Example2/ 21.57 | I-35/ 0.75 | 6.25 | 0.02 | 1.99 | 1.20 | 68.22 |
| **Example 20** | Synthesis Example2/ 21.57 | I-38/ 0.75 | 6.25 | 0.02 | 1.99 | 1.20 | 68.22 |
| **Example 21** | Synthesis Example2/ 21.57 | I-41/ 0.75 | 6.25 | 0.02 | 1.99 | 1.20 | 68.22 |
| **Example 22** | Synthesis Example2/ 21.57 | I-44/ 0.75 | 6.25 | 0.02 | 1.99 | 1.20 | 68.22 |
| **Example 23** | Synthesis Example2/ 21.57 | I-46/ 0.75 | 6.25 | 0.02 | 1.99 | 1.20 | 68.22 |
| **Example 24** | Synthesis Example2/ 21.57 | I-48/ 0.75 | 6.25 | 0.02 | 1.99 | 1.20 | 68.22 |
| **Example 25** | Synthesis Example2/ 21.57 | I-49/ 0.75 | 6.25 | 0.02 | 1.99 | 1.20 | 68.22 |
| **Example 26** | Synthesis Example2/ 21.57 | I-51/ 0.75 | 6.25 | 0.02 | 1.99 | 1.20 | 68.22 |
| **Example 27** | Synthesis Example2/ 21.57 | I-53/ 0.75 | 6.25 | 0.02 | 1.99 | 1.20 | 68.22 |
| **Example 28** | Synthesis Example2/ 21.57 | I-56/ 0.75 | 6.25 | 0.02 | 1.99 | 1.20 | 68.22 |
| **Example 29** | Synthesis Example2/ 21.57 | I-60/ 0.75 | 6.25 | 0.02 | 1.99 | 1.20 | 68.22 |
| **Comparati ve Example 1** | Synthesis Example1/ 21.57 | I-1/ 0.05 | 6.25 | 0.02 | 1.99 | 1.20 | 68.92 |
| **Comparati ve Example 2** | Synthesis Example1/ 21.57 | I-1/ 10.5 | 6.25 | 0.02 | 1.99 | 1.20 | 58.47% |
| **Comparati ve Example 3** | Synthesis Example2/ 21.57 | I-61/ 0.75 | 6.25 | 0.02 | 1.99 | 1.20 | 68.22% |
| **Comparati ve Example 4** | Synthesis Example2/ 21.57 | I-62/ 0.75 | 6.25 | 0.02 | 1.99 | 1.20 | 68.22% |
| **Comparati ve Example 5** | Synthesis Example2/ 21.57 | I-63/ 0.75 | 6.25 | 0.02 | 1.99 | 1.20 | 68.22% |
| **Comparati ve Example 6** | Synthesis Example2/ 21.57 | I-64/ 0.75 | 6.25 | 0.02 | 1.99 | 1.20 | 68.22% |

The structures of the oxime ester-based initiator used in the compositions in Comparative Examples 3 to 6 are I-61 to I-64.

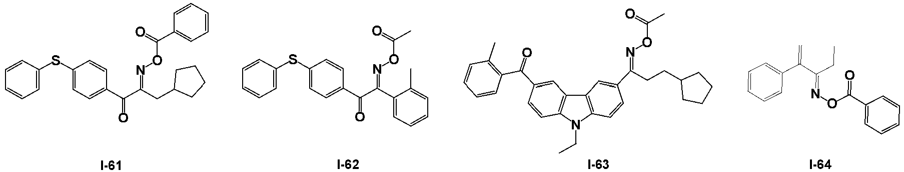

The method for preparing specimens for pattern evaluation using the negative photosensitive composition is as follows.

### (1) Application and coating steps

The photosensitive composition is a low-viscosity liquid-phase sample, and a spin coater or slit coater is used to coat the substrate to a certain thickness after application. The spin coater has an advantage in that although the thickness is reduced as the rotation speed increases, the flatness deviation in the area is reduced, and a slit coater is preferred to a spin coater for coating a large-area substrate. Due to the solvent remaining after the coating step, the surface exhibits fluidity, which in turn degrades surface planarity. In order to overcome this issue, a vacuum chamber dry (VCD) process is employed to partially remove the solvent, thereby reducing the surface fluidity.

### (2) Prebaking step

This process involves heating the coated substrate at a specified temperature and time using a hot plate or oven to remove some of the solvent contained in the coating film. If the surface or deep portion of the coating film does not dry, contamination of the photomask may occur during exposure in the following process, and the exposed area may not cure properly when exposed to UV light, and due to this lack of curing, the pattern is not formed and is removed during the development process.

### (3) Exposure step

After the completion of the prebaking process, this is the process of curing the formed film by irradiating it with an active ray (ultraviolet rays) using a photomask with a formed pattern. The types of lamps that generate active rays include LED lamps and metal (mercury) lamps, and the wavelengths include g-line (436 nm), h-line (405 nm), i-line (365 nm), and deep UV (<260 nm), and they can be used alone or in combination.

### (4) Development step

In the exposure step above, when the active ray is irradiated, the exposed part and the non-exposed part are divided by the photomask. In the case of the positive type, the exposed part is dissolved by the developer, and the non-exposed part resists the developer and a pattern remains. In the case of the negative type, the exposed part is cured and has resistance to the developer, and the non-exposed part is developed. The composition of the present disclosure is divided into an exposed part (cured) and a non-exposed part (developed) in the negative type, and thereby a pattern is formed.

### (5) Post-baking step

This process involves heating the developed substrate to a temperature of 210°C or higher to remove any remaining solvent and fumes. Failure to completely remove the solvent and fumes during this process will lead to generation of outgas during the post-heat treatment process, which will affect the device and result in dark spots or shrinkage.

### (6) Hole pattern accuracy and taper angle measurement

The cross-sections of the specimens obtained in Examples and Comparative Examples during the post-baking treatment step were measured using JSM-IT800, which is a scanning electron microscope of JEOL, to determine the taper angles.

**[Table 2]**

| | Presence or Absence of Residue after Development | Hole Pattern Accuracy (30 µm) | | Taper Angle of Pattern (°) |
|---|---|---|---|---|
| | | Measured Value (µm) | Accuracy (%) | |
| Example 1 | X | 29.6978 | 98.99 | 79.5 |
| Example 2 | X | 29.8234 | 99.41 | 80.5 |
| Example 3 | X | 29.8475 | 99.49 | 79.1 |
| Example 4 | X | 29.7152 | 99.05 | 76.3 |
| Example 5 | X | 29.8431 | 99.48 | 77.9 |
| Example 6 | X | 29.5925 | 98.64 | 76.5 |
| Example 7 | X | 29.7341 | 99.11 | 78.2 |
| Example 8 | X | 29.8012 | 99.34 | 79.8 |
| Example 9 | X | 29.6543 | 98.85 | 77.1 |
| Example 10 | X | 29.7892 | 99.30 | 80.1 |
| Example 11 | X | 29.8321 | 99.44 | 78.7 |
| Example 12 | X | 29.6789 | 98.93 | 76.9 |
| Example 13 | X | 29.7567 | 99.19 | 79.3 |
| Example 14 | X | 29.8105 | 99.37 | 77.5 |
| Example 15 | X | 29.6234 | 98.75 | 78.4 |
| Example 16 | X | 29.7987 | 99.33 | 80.1 |
| Example 17 | X | 29.8412 | 99.47 | 79.6 |
| Example 18 | X | 29.7056 | 99.02 | 76.7 |
| Example 19 | X | 29.6873 | 98.96 | 77.8 |
| Example 20 | X | 29.8294 | 99.43 | 78.9 |
| Example 21 | X | 29.7456 | 99.15 | 79.2 |
| Example 22 | X | 29.6612 | 98.87 | 77.3 |
| Example 23 | X | 29.8034 | 99.35 | 80.3 |
| Example 24 | X | 29.7210 | 99.07 | 78.1 |
| Example 25 | X | 29.8376 | 99.46 | 79.4 |
| Example 26 | X | 29.6421 | 98.81 | 76.6 |
| Example 27 | X | 29.7751 | 99.25 | 77.7 |
| Example 28 | X | 29.8167 | 99.39 | 78.5 |
| Example 29 | X | 29.6988 | 99.00 | 79.0 |
| Comparative Example 1 | X | 27.5654 | 91.89 | 97.1 |
| Comparative Example 2 | ○ | 33.8492 | 87.17 | 48.5 |
| Comparative Example 3 | Δ | 25.1542 | 83.85 | 49.6 |
| Comparative Example 4 | Δ | 26.9872 | 89.96 | 45.3 |
| Comparative Example 5 | Δ | 26.9872 | 89.96 | 45.3 |
| Comparative Example 6 | Δ | 28.2865 | 94.29 | 71.6 |

| | | | | |
|---|---|---|---|---|
| *Presence/absence of residue: No residue (X) / Slight residue (△) / Heavy residue (∘) | | | | |

As can be seen in Table 2 above, it was confirmed that no residue was left after development in Examples 1 to 29 containing an oxime ester-based initiator. In contrast, it was confirmed that a significant residue remained in Comparative Example 2 containing an excessive amount of initiator. This is because radicals propagated beyond the light-irradiated area after the excessive amount of initiator was photoinitiated, thereby causing curing of the unexposed area. In addition, it was confirmed that residue remained on the edge of the pattern in Comparative Examples 3 to 6. This is because the initiators used in Comparative Examples 3 to 5 structurally have a higher rate of light absorption than the initiators used in Examples 1 to 29, which increases sensitivity and causes radicals to quickly propagate to the unexposed area.

In Examples 1 to 29, it was confirmed that the taper angle was formed as 76.5° to 80.5°. In contrast, in the case of Comparative Example 1, which has a lower initiator content than the range presented in this patent, it was confirmed that a reverse taper angle was formed with a taper angle of 97.1°, which means that the cured film was not properly cured due to a small amount of initiator. In the case of Comparative Example 2, which has a high initiator content, it was confirmed that the taper angle was formed as very low as 48.5°, which can be seen as being caused by easy curing of the unexposed area due to diffuse reflection of the irradiated light source.

In addition, as a result of confirming the accuracy of pattern implementation using a 30µm Hole mask, it was confirmed that while all of Examples 1 to 29 accurately implemented patterns with an accuracy of 98% or more within 0.5 µm, Comparative Examples 1 to 6 showed an accuracy of less than 95% and an error of up to 5 µm.

Therefore, it can be confirmed that the selection of the oxime ester-based initiator according to the present disclosure is effective in improving the residue of the pattern and implementing an accurate pattern.

The present disclosure is not limited to the Examples above but may be prepared in various different forms.

The above description is merely illustrative of the present disclosure, and those skilled in the art to which the present disclosure pertains will be able to make various modifications without departing from the essential characteristics of the present disclosure.

Accordingly, the embodiments disclosed in this specification are for illustrative purposes only and are not intended to limit the present disclosure, and the spirit and scope of the present disclosure are not limited by these embodiments. The scope of protection of the present disclosure should be interpreted in accordance with the claims, and all technologies within the scope equivalent thereto should be interpreted as being included in the scope of rights of the present disclosure.

## Claims

1. A negative photosensitive composition comprising a polyimide-based precursor; and an initiator represented by Formula I below: 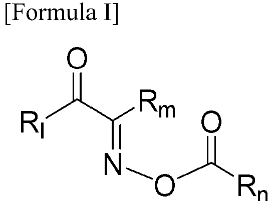 wherein in Formula I above,
R₁ to Rₙ are each independently selected from the group consisting of hydrogen; deuterium; a C₁₋₃₀ alkyl group; a C₁₋₃₀ alkylene group; a C₂-C₂₀ alkenyl group; a C₂-C₂₀ alkynyl group; a C₃₋₃₀ cycloalkyl group; a C₂₋₃₀ alkylcycloalkyl group; a C₆₋₃₀ aryl group; a fused ring group of a C₆₋₃₀ aliphatic ring and a C₆₋₃₀ aromatic ring; a C₂₋₃₀ alkenyl group; a C₂₋₃₀ alkynyl group; a C₁₋₃₀ alkoxy group; a C₆₋₃₀ aryloxy group; a carbonyl group; an ether group; and a combination thereof, and
R₁ to Rₙ are each independently further substituted with one or more substituents selected from the group consisting of hydrogen; deuterium; a C₁₋₃₀ alkyl group; a C₁₋₃₀ alkylene group; a C₂-C₂₀ alkenyl group; a C₂-C₂₀ alkynyl group; a C₃₋₃₀ cycloalkyl group; a C₂₋₃₀ alkylcycloalkyl group; a C₆₋₃₀ aryl group; a fused ring group of a C₆₋₃₀ aliphatic ring and a C₆₋₃₀ aromatic ring; a C₂₋₃₀ alkenyl group; a C₂₋₃₀ alkynyl group; a C₁₋₃₀ alkoxy group; a C₆₋₃₀ aryloxy group; a carbonyl group; an ether group; and a combination thereof, or form a ring between neighboring substituents.

2. The negative photosensitive composition of claim 1, wherein the compound of Formula I comprises Formula J below: 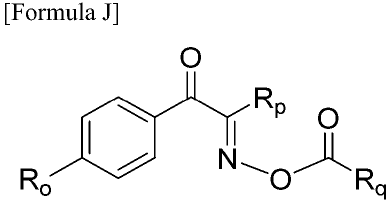 wherein in Formula J above,
Rₒ is hydrogen or a C₁₋₁₀ alkyl group,
Rₚ to R_{q} are each independently selected from the group consisting of hydrogen; deuterium; a C₁₋₃₀ alkyl group; a C₁₋₃₀ alkylene group; a C₂-C₂₀ alkenyl group; a C₂-C₂₀ alkynyl group; a C₃₋₃₀ cycloalkyl group; a C₂₋₃₀ alkylcycloalkyl group; a C₆₋₃₀ aryl group; a fused ring group of a C₆₋₃₀ aliphatic ring and a C₆₋₃₀ aromatic ring; a C₂₋₃₀ alkenyl group; a C₂₋₃₀ alkynyl group or C₁₋₃₀ alkoxy group; a carbonyl group; an ether group; and a combination thereof, and
Rₚ to R_{q} are each independently further substituted with one or more substituents selected from the group consisting of hydrogen; deuterium; a C₁₋₃₀ alkyl group; a C₁₋₃₀ alkylene group; a C₂-C₂₀ alkenyl group; a C₂-C₂₀ alkynyl group; a C₃₋₃₀ cycloalkyl group; a C₂₋₃₀ alkylcycloalkyl group; a C₆₋₃₀ aryl group; a fused ring group of a C₆₋₃₀ aliphatic ring and a C₆₋₃₀ aromatic ring; a C₂₋₃₀ alkenyl group; a C₂₋₃₀ alkynyl group; a C₁₋₃₀ alkoxy group; a C₆₋₃₀ aryloxy group; a carbonyl group; an ether group; and a combination thereof, or form a ring between neighboring substituents.

3. The negative photosensitive composition of claim 1, wherein the compound represented by Formula I is selected from Formulas I-1 to I-60 below:

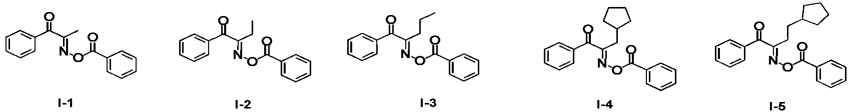

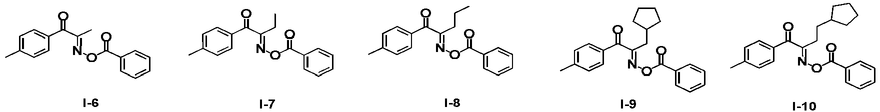

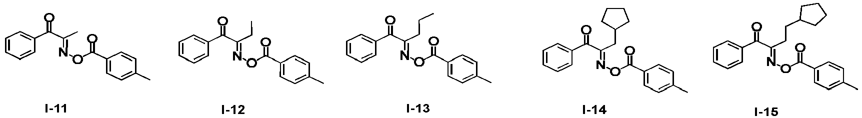

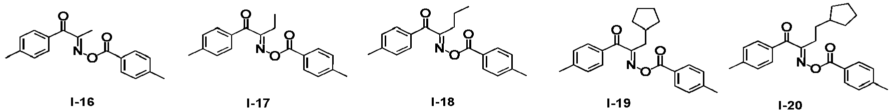

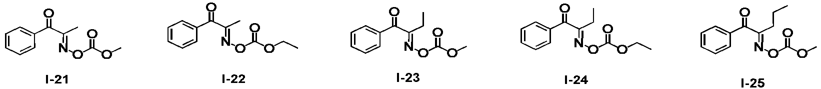

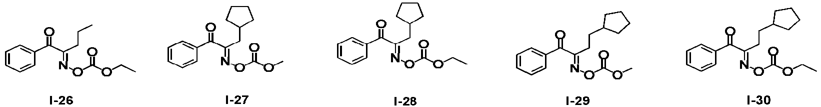

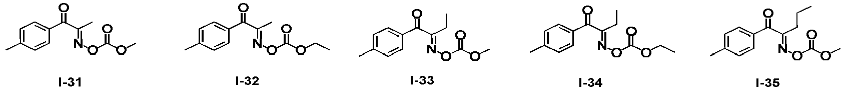

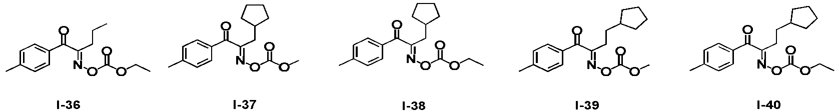

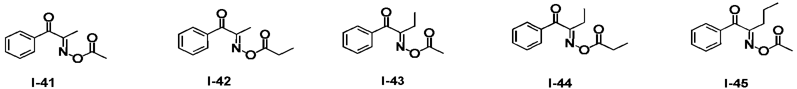

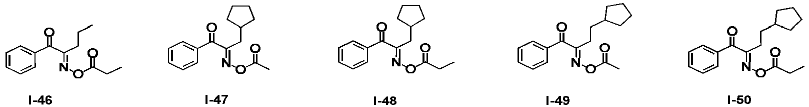

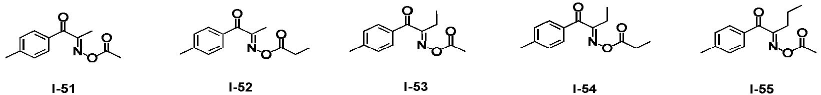

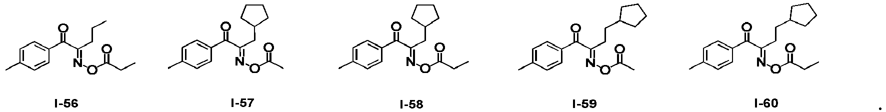

4. The negative photosensitive composition of claim 1, wherein the repeating unit of the polyimide-based precursor comprises a repeating unit selected from the group consisting of the following Formulas 1-1 and 1-2, and a combination thereof: 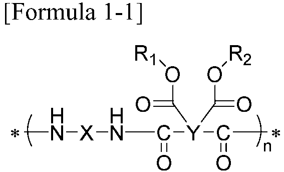 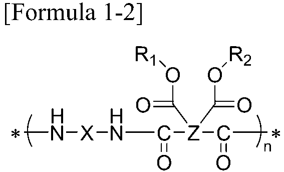 wherein in Formulas 1-1 and Formula 1-2 above,
1) * represents a repeating unit or a part where a bond is connected by a reactive end group represented by Formula Q of claim 2,
2) R₁ to R₄ are Formula 2 below,
3) X is Formula 3 below,
4) m and n are an integer of 1 to 1000, 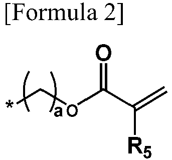 wherein in Formula 2 above,
5) * represents a part where a bond is connected,
6) a is an integer of 1 to 30,
7) R₅ is hydrogen or methyl,
8) Y is selected from the group consisting of a C₆-C₃₀ arylene group; a C₂₋₃₀ heterocyclic group comprising at least one heteroatom among O, N, S, Si, and P; a fused ring group of a C₆₋₃₀ aliphatic ring and a C₆₋₃₀ aromatic ring; a C₁₋₂₀ alkylene group; a C₁₋₂₀ cycloalkylene group; a C₂₋₂₀ alkenylene group; a C₃₋₂₀ cycloalkenylene group; a C₂₋₂₀ alkynylene group; a C₃₋₂₀ cycloalkynylene group; Formula 3; and a combination thereof,
9) Z is selected from the group consisting of a C₆-C₃₀ arylene group; a C₂₋₃₀ heterocyclic group comprising at least one heteroatom among O, N, S, Si, and P; a fused ring group of a C₆₋₃₀ aliphatic ring and a C₆₋₃₀ aromatic ring; a C₁₋₂₀ alkylene group; a C₁₋₂₀ cycloalkylene group; a C₂₋₂₀ alkenylene group; a C₃₋₂₀ cycloalkenylene group; a C₂₋₂₀ alkynylene group; a C₃₋₂₀ cycloalkynylene group; Formula 3; and a combination thereof, 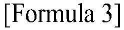 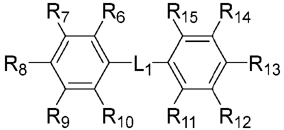
10) L₁ is selected from the group consisting of a single bond, -CH₂-, -CH₂CH₂-, - CH₂OCH₂-, -CH(CH₃)-, -C(CH₃)₂-, -O-, -CH(CF₃)-, -C(CF₃)₂-, -S-, -SO₂-, Si(CH₃)₂-, -C₆H₄-, - OC₆H₄0-, -CO-, -NHCO-, AND -COO-,
11) two of R₆ to R₁₅ are connection parts with an amide group of Formula 1-1 or Formula 1-2 above,
12) the remaining ones of R₆ to R₁₅ excluding the connection parts are each independently hydrogen; deuterium; a hydroxy group; a C₆₋₃₀ aryl group; a C₂₋₃₀ heterocyclic group comprising at least one heteroatom among O, N, S, Si, and P; a fused ring group of a C₆₋₃₀ aliphatic ring and a C₆₋₃₀ aromatic ring; a C₁-₂₀ alkyl group; a C₂-₂₀ alkenyl group; a C₂-₂₀ alkynyl group; a C₁-₂₀ alkoxy group; a C₆-₃₀ aryloxy group; a fluorenyl group; a carbonyl group; an ether group; a carboxyl group; a C₁-₂₀ alkoxycarbonyl group; or neighboring R₆ and R₁₅, and R₁₀ and R₁₁ form a ring, and
13) the rings formed by binding between Y, Z, R₆ to R₁₅, and neighboring groups are each further substituted with one or more substituents selected from the group consisting of deuterium; a halogen; a silane group substituted or unsubstituted with a C₁-₃₀ alkyl group or C₆-₃₀ aryl group; a siloxane group; a boron group; a germanium group; a cyano group; an amino group; a nitro group; a C₁₋₃₀ alkylthio group; a C₁₋₃₀ alkoxy group; a C₆₋₃₀ arylalkoxy group; a C₁₋₃₀ alkyl group; a C₂₋₃₀ alkenyl group; a C₂₋₃₀ alkynyl group; a C₆₋₃₀ aryl group; a C₆₋₃₀ aryl group substituted with deuterium; a fluorenyl group; a C₂₋₃₀ heterocyclic group comprising at least one heteroatom among O, N, S, Si, and P; a C₃₋₃₀ alicyclic group; a C₇₋₃₀ arylalkyl group; a C₈₋₃₀ arylalkenyl group; and a combination thereof; or form a ring between neighboring substituents.

5. The negative photosensitive composition of claim 1, wherein the polyimide-based precursor comprises a repeating unit; and a reactive end group represented by Formula Q that binds to an end of the polyimide-based repeating unit: 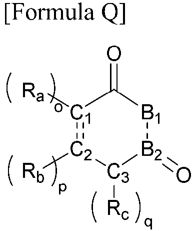 wherein in Formula Q above,
1) Rₐ to R_{c} are each independently hydrogen; deuterium; a hydroxy group; a C₆₋₃₀ aryl group; a C₂₋₃₀ heterocyclic group comprising at least one heteroatom among O, N, S, Si, and P; a fused ring group of a C₆₋₃₀ aliphatic ring and a C₆₋₃₀ aromatic ring; a C₁-₃₀ alkyl group; a C₂-₃₀ alkenyl group; a C₂-₃₀ alkynyl group; a C₁-₃₀ alkoxy group; a C₆₋₃₀ aryloxy group; a C₁₋₃₀ hydroxyacryl group; a C₁₋₃₀ hydroxymethaacryl group; a fluorenyl group; a carbonyl group; an ether group; a carboxyl group; or a C₁-₃₀ alkoxycarbonyl group; or the neighboring groups of Rₐ to R_{c} form a ring,
2) C₁ and C₂ are carbon; the double dotted line connecting C₁ and C₂ is a single bond or double bond,
3) when the double dotted line connecting C₁ and C₂ is a single bond, o and p are each independently an integer of 1 or 2; and when the double dotted line connecting C₁ and C₂ is a double bond, o and p are each an integer of 1;
4) C₃ is carbon or a direct bond of C₂-B₂,
5) when C₃ is carbon, q is an integer of 1 or 2,
6) the dotted line connecting B₁ and B₂ indicates that the bond is absent or is a single bond,
7) when the bond of the dotted line connecting B₁ and B₂ above is absent, B₁ is hydrogen; deuterium; a hydroxy group; a C₆₋₃₀ aryl group; a C₂₋₃₀ heterocyclic group comprising at least one heteroatom among O, N, S, Si, and P; a fused ring group of a C₆₋₃₀ aliphatic ring and a C₆₋₃₀ aromatic ring; a C₁-₂₀ alkyl group; a C₂-₂₀ alkenyl group; a C₂-₂₀ alkynyl group; a C₁-₂₀ alkoxy group; a C₆₋₃₀ aryl group; a C₁₋₂₀hydroxyacryl group; a C₁₋₂₀ hydroxymethaacryl group; a fluorenyl group; a carbonyl group; an ether group; a carboxyl group; or a C₁-₂₀ alkoxycarbonyl group; and B₂ is carbon connected to a polyimide-based repeating unit,
8) when the dotted line connecting B₁ and B₂ above is a single bond, B₁ is nitrogen connected to the polyimide-based repeating unit; and B₂ is carbon, and
9) the rings formed by binding between Rₐ to R_{c} and neighboring groups are each further substituted with one or more substituents selected from the group consisting of deuterium; a halogen; a silane group substituted or unsubstituted with a C₁-₃₀ alkyl group or C₆-₃₀ aryl group; a siloxane group; a boron group; a germanium group; a cyano group; an amino group; a nitro group; a C₁₋₃₀ alkylthio group; a C₁₋₃₀ alkoxy group; a C₆₋₃₀ arylalkoxy group; a C₁₋₃₀ alkyl group; a C₂₋₃₀ alkenyl group; a C₂₋₃₀ alkynyl group; a C₆₋₃₀ aryl group; a C₆₋₃₀ aryl group substituted with deuterium; a fluorenyl group; a C₂₋₃₀ heterocyclic group comprising at least one heteroatom among O, N, S, Si, and P; a C₃₋₃₀ alicyclic group; a C₇₋₃₀ arylalkyl group; a C₈₋₃₀ arylalkenyl group; and a combination thereof; or form a ring between neighboring substituents.

6. The negative photosensitive composition of claim 5, wherein the compound represented by Formula Q above comprises compounds represented by Formulas Q-1 to Q-6: 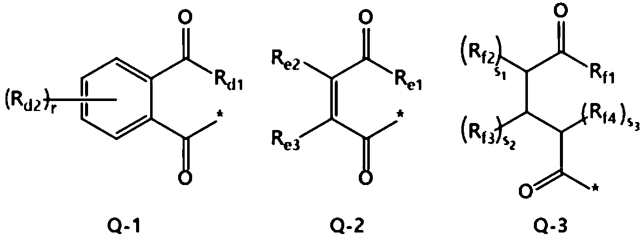 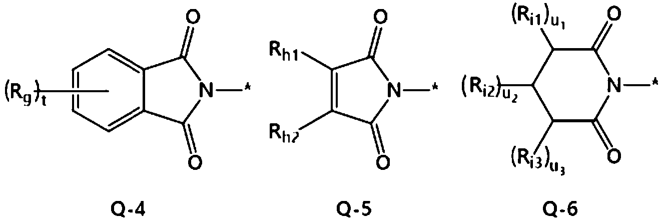 wherein in Formulas Q-1 to Q-6 above,
1) R_{d1}, R_{d2}, Rₑ₁ to Rₑ₃, R_{f1} to R_{f4}, R_{g}, Rₕ₁, Rₕ₂,, and Rᵢ₁ to Rᵢ₃ are each independently hydrogen; deuterium; a hydroxy group; a C₆₋₃₀ aryl group; a C₂₋₃₀ heterocyclic group comprising at least one heteroatom among O, N, S, Si, and P; a fused ring group of a C₆₋₃₀ aliphatic ring and a C₆₋₃₀ aromatic ring; a C₁-₃₀ alkyl group; a C₂-₃₀ alkenyl group; a C₂-₃₀ alkynyl group; a C₁-₃₀ alkoxy group; a C₆-₃₀ aryloxy group; a C₁₋₃₀hydroxyacryl group; a C₁₋₃₀ hydroxymethaacryl group; a fluorenyl group; a carbonyl group; an ether group; a carboxyl group; or a C₁-₃₀ alkoxycarbonyl group;
2) r and t are an integer of 0 to 4, and
3) s₁, s₂, and u₁ to u₃ are each independently an integer of 1 or 2.

7. The negative photosensitive composition of claim 1, wherein the repeating unit of the polyimide-based precursor comprises a diamine monomer; a dianhydride monomer; and an anhydride monomer.

8. The negative photosensitive composition of claim 1, wherein the weight average molecular weight of the polyimide-based precursor is 5,000 g/mol to 40,000 g/mol.

9. The negative photosensitive composition of claim 1, further comprising a reactive unsaturated compound; a solvent; and other additives.

10. The negative photosensitive composition of claim 1, wherein the initiator is included in an amount of 0.01 wt% to 10 wt% based on the total amount of the negative photosensitive composition.

11. The negative photosensitive composition of claim 1, wherein the polyimide-based precursor is included in an amount of 5 wt% to 50 wt% based on the total amount of the negative photosensitive composition.

12. A film prepared from the negative photosensitive composition of claim 1.

13. A semiconductor device prepared using the film of claim 12.

14. A display device prepared using the film of claim 12.

15. An electronic device comprising the display device of claim 14 and a control unit for driving the display device.
